# EUROPEAN PATENT APPLICATION

(11) **EP 2 067 806 A1**
(43) Date of publication of application: **10.06.2009**
(21) Application number: 07828484.1
(22) Date of filing: 19.09.2007
(51) Int. Cl.: C08G 61/12, C08L 65/00, G01J 1/02, H01L 27/14, H01L 51/05, H01L 51/30, H01L 51/42

(54) **ORGANIC PHOTOELECTRIC CONVERSION DEVICE AND POLYMER USEFUL FOR PRODUCING THE SAME**

(30) Priority: 26.09.2006 JP 2006260251
(71) Applicant: Sumitomo Chemical Company, Limited, Tokyo 104-8260 (JP)
(72) Inventor: UEDA, Masato, Tsukuba-shi, Ibaraki 305-0046 (JP)
(74) Representative: Duckworth, Timothy John
(86) International application number: PCT/JP2007/068738
(87) International publication number: WO 2008/041597

(57) **Abstract**

Disclosed is a polymer containing a repeating unit (repeating unit A) composed of one structure represented by the formula (1) below one structure represented by the formula (2) below and one or more structures represented by the formula (3) below. In this polymer, the difference between the maximum number of carbons in the carbon main chain contained in an alkyl group represented by R¹ or R² and the maximum number of carbons in the carbon main chain contained in an alkyl group represented by R³ or R⁴ is 0 or 1.

## Description

### TECHNICAL FIELD

The present invention relates to an organic photoelectric conversion device and a polymer useful for producing the same.

### BACKGROUND ART

An organic semiconductor material having charge (electrons, holes) transportability is expected to apply to organic electroluminescent devices, organic transistors and organic photoelectric conversion devices (organic solar batteries, light sensors and the like) and is variously studied.

An organic semiconductor material is demanded to be high in charge transportability from the viewpoint of improving performance of organic photoelectric conversion devices. Furthermore, the organic semiconductor material is demanded to be excellent in solubility in an organic solvent from the viewpoint of enabling to produce organic photoelectric conversion devices by coating at low cost.

In order to increase the charge transportability of an organic semiconductor material, it is important to promote an interaction between molecules by use of a compound in which a π conjugation expands to make packing between molecules denser. From this point of view, aromatic ring compounds are variously studied. Specifically, in order to increase the planarity of a molecule, thiophene-linked compounds are variously studied and, for example, fluorene-co-bithiophene that shows high hole transportability has been proposed (see, H. Sirringhaus et al.: Science, 2000, Vol. 290, 2123). However, there is a problem in that fluorene-co-bithiophene has low solubility in organic solvents. In this connection, various studies have been further conducted to improve the solubility and fluorene-co-pentathiophene of which solubility is improved has been proposed (see, Brennan, David J et al.: Mat. Res. Soc. Symp. Proc., 2004. 814.).

However, fluorene-co-pentathiophene is still insufficient in the solubility; accordingly, a compound excellent in both of charge transportability and solubility in organic solvents is demanded to develop.

In this connection, the present invention intends to provide compounds excellent in both of charge transportability and solubility in organic solvents.

### DISCLOSURE OF THE INVENTION

The present invention firstly provides a polymer comprising a repeating unit (repeating unit A) comprising one structural unit represented by a formula (1) shown below, one structural unit represented by a formula (2) shown below, and at least one structural unit represented by a formula (3) shown below, **characterized in that** a difference between a maximum carbon number of a carbon main chain contained in an alkyl group represented by R¹ or R² and a maximum carbon number of a carbon main chain contained in an alkyl group represented by R³ or R⁴ is 0 or 1: 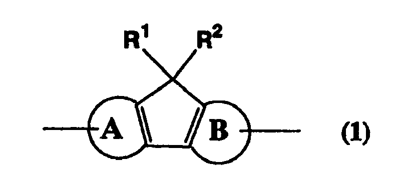 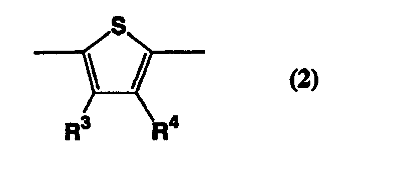 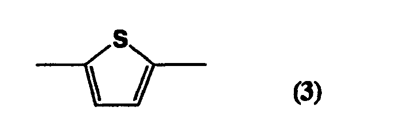 wherein an A ring and a B ring each independently represent an optionally substituted benzene ring and have a bond on the benzene ring; R¹, R², R³ and R⁴ each independently represent a hydrogen atom, a straight or branched alkyl group having 1 to 20 carbon atoms, an alkoxy group having 1 to 20 carbon atoms or an aryl group having 6 to 60 carbon atoms, where some of or all of hydrogen atoms in the groups may be replaced by fluorine atom(s) and the aryl group may be optionally substituted; provided that at least one of R¹ and R² is the alkyl group, and at least one of R³ and R⁴ is the alkyl group.

The present invention secondly provides a composition comprising the polymer shown above.

The present invention thirdly provides an organic photoelectric conversion device comprising a pair of electrodes at least one of which is transparent or semitransparent, a first organic layer disposed between the electrodes and containing an electron acceptor compound, and a second organic layer disposed adjacent to the first organic layer and containing an electron donor compound, **characterized in that** the electron donor compound is the polymer shown above.

The present invention fourthly provides an organic photoelectric conversion device comprising a pair of electrodes at least one of which is transparent or semitransparent, and at least one layer of an organic layer disposed between the electrodes and containing an electron acceptor compound and an electron donor compound, **characterized in that** the electron donor compound is the polymer shown above.

The present invention fifthly provides an organic thin film solar battery module and an organic image sensor obtained by stacking a plurality of the organic photoelectric conversion devices.

The present invention sixthly provides a polymer comprising a repeating unit (repeating unit C) comprising one structural unit represented by a formula (19) shown below, one structural unit represented by a formula (20) shown below, and at least one structural unit represented by a formula (21) shown below: 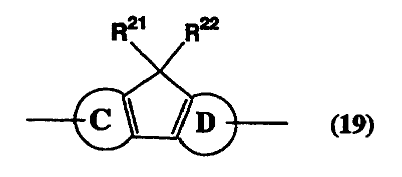 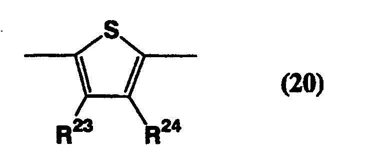 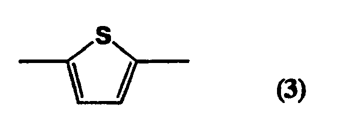 wherein a C ring and a D ring each independently represent an optionally substituted aromatic ring and have a bond on the aromatic ring. R²¹, R²², R²³ and R²⁴ each independently represent a hydrogen atom, an alkyl group having 1 to 20 carbon atoms, an alkoxy group having 1 to 20 carbon atoms or an aryl group having 6 to 60 carbon atoms, where some of or all of hydrogen atoms in the groups may be replaced by fluorine atom(s) and the aryl group may be optionally substituted; provided that at least one of R²³ and R²⁴ is not a hydrogen atom, and at least one of the C ring and the D ring is not a benzene ring.

The present invention seventhly provides a composition containing the polymer shown above.

The present invention eighthly provides an organic photoelectric conversion device comprising a pair of electrodes at least one of which is transparent or semitransparent, a first organic layer that is disposed between the electrodes and containing an electron acceptor compound, and a second organic layer disposed adjacent to the first organic layer and containing an electron donor compound, **characterized in that** the electron donor compound is the polymer shown above.

The present invention ninthly provides an organic photoelectric conversion device having a pair of electrodes at least one of which is transparent or semitransparent, and at least one layer of an organic layer disposed between the electrodes and containing an electron acceptor compound and an electron donor compound, **characterized in that** the electron donor compound is the polymer shown above.

The present invention tenthly provides an organic thin film solar battery module and an organic image sensor formed by stacking a plurality of the organic photoelectric conversion devices shown above.

### BRIEF DESCRIPTION OF THE DRAWINGS

Fig. 1 is a schematic diagram of an organic photoelectric conversion device involving a first embodiment;
Fig. 2 is a schematic diagram of an organic photoelectric conversion device involving a second embodiment; and
Fig. 3 is a schematic diagram of an organic photoelectric conversion device involving a third embodiment.

### DESCRIPTION OF REFERENCE NUMERALS

- 1: Substrate
- 2: An organic film containing an electron donor compound and an electron acceptor compound (organic layer)
- 3: An organic film containing an electron donor compound (organic layer)
- 4: An organic film containing an electron acceptor compound (organic layer)
- 7a: A first electrode
- 7b: A second electrode
- 100: An organic photoelectric conversion device involving a first embodiment
- 110: An organic photoelectric conversion device involving a second embodiment
- 120: An organic photoelectric conversion device involving a third embodiment

### BEST MODE FOR CARRYING OUT THE INVENTION

In what follows, the present invention will be explained in detail with reference to the drawings as required. In the drawings, the same elements are represented by the same reference numerals and a duplicating description thereof will be omitted. Positional relationships of up and down and right and left are as shown in the drawings unless stated clearly. Dimensional ratios of the drawings are not particularly restricted. Furthermore, in the specification, simple descriptions such as "C₆H₁₃", "C₈H₁₇" and so on mean "n-C₆H₁₃", "n-C₈H₁₇" and so on.

### <Polymer>

A first polymer of the present invention is a polymer comprising a repeating unit (repeating unit A) comprising one structural unit represented by the formula (1), one structural unit represented by the formula (2) and at least one structural unit represented by the formula (3), **characterized in that** a difference between a maximum carbon number of a carbon main chain contained in an alkyl group represented by R¹ or R² and a maximum carbon number of a carbon main chain contained in an alkyl group represented by R³ or R⁴ is 0 or 1.

A second polymer of the present invention comprises a repeating unit (repeating unit C) comprising one structural unit represented by the formula (19), one structural unit represented by the formula (20) and at least one structural unit represented by the formula (21).

A polymer having such a repeating unit has a thiophene ring structure and thereby is excellent in π conjugation planarity between rings. Furthermore, since a substituent is introduced, the polymer is chemically stabilized and excellent in solubility in organic solvents.

In the repeating units A and C, preferably 3 to 6 and more preferably 4 to 6 structural units represented by the formulas (3) and (21) are contained.

In the present specification, "a maximum carbon number of a carbon main chain contained in an alkyl group" means the number of total constituting carbon atoms in a straight chain alkyl group and the number of carbon atoms constituting the longest (that is, the largest carbon number) straight chain portion in a branched alkyl group. For example, in a 2-ethylhexyl group, a hexyl group is the longest straight chain portion and the number of carbon atoms constituting the hexyl group is 6.

In the formula (1), examples of substituents in an optionally substituted benzene ring represented by an A ring and a B ring include straight, branched or cyclic alkyl groups having 1 to 20 carbon atoms, and alkoxy groups containing the alkyl group in a structure and having 1 to 20 carbon atoms, and straight, branched or cyclic alkyl groups having 1 to 12 carbon atoms are preferred.

Furthermore, the C ring and the D ring in the formula (19) each independently represent an optionally substituted aromatic ring. Examples of aromatic ring include aromatic hydrocarbon rings such as a benzene ring, a naphthalene ring, an anthracene ring, a tetracene ring, a pentacene ring, a pyrene ring, and a phenanthrene ring; and heteroaromatic rings such as a pyridine ring, a bipyridine ring, a phenanthroline ring, a quinoline ring, an isoquinoline ring, a thiophene ring, a furan ring and a pyrrole ring, and a benzene ring, a naphthalene ring, a pyridine ring and a thiophene ring are preferred. However, at least one of the C ring and D ring is not a benzene ring. Furthermore, at least one of the C ring and D ring is preferably an optionally substituted naphthalene ring.

In the formulas (1), (2), (19) and (20), examples of straight or branched alkyl groups represented by R¹, R², R³, R⁴, R²¹, R²², R²³ and R²⁴ and having 1 to 20 carbon atoms include a methyl group, an ethyl group, an n-propyl group, an iso-propyl group, an n-butyl group, an iso-butyl group, a tert-butyl group, a 3-methylbutyl group, a pentyl group, a hexyl group, a 2-ethylhexyl group, a heptyl group, an octyl group, a nonyl group, a decyl group, a lauryl group and so on, and alkyl groups having 1 to 10 carbon atoms are preferred, and a pentyl group, a hexyl group, a 2-ethylhexyl group, an octyl group and a decyl group are more preferred. Some of or all of hydrogen atoms in the alkyl group shown above may be replaced by fluorine atom(s).

In the formulas (1), (2), (19) and (20), examples of alkoxy groups represented by R¹, R², R³, R⁴, R²¹, R²², R²³ and R²⁴ and having 1 to 20 carbon atoms include those obtained by bonding the alkyl groups and an oxygen atom. Some of or all of hydrogen atoms in the alkoxy group shown above may be replaced by fluorine atom(s).

In the formulas (1), (2), (19) and (20), examples of aryl groups represented by R¹, R², R³, R⁴, R²¹, R²², R²³ and R²⁴ and having 6 to 60 carbon atoms include a phenyl group, a C₁ to C₁₂ alkoxyphenyl group (The "C₁ to C₁₂ alkoxy" means that carbon number of an alkoxy portion is 1 to 12. Same in what follows.), a C₁ to C₁₂ alkylphenyl group (The "C₁ to C₁₂ alkyl" means that carbon number of an alkyl portion is 1 to 12. Same in what follows.), a 1-naphtyl group, a 2-naphthyl group and so on, and aryl groups having 6 to 20 carbon atoms are preferred, and C₁ to C₁₂ alkoxyphenyl groups and C₁ to C₁₂ alkylphenyl groups are more preferred. The aryl group may be optionally substituted. Examples of the substituents include straight, branched or cyclic alkyl groups having 1 to 20 carbon atoms, alkoxy groups containing a straight, branched or cyclic alkyl group having 1 to 20 carbon atoms in their structures, and so on, and straight, branched or cyclic alkyl groups having 1 to 12 carbon atoms are preferred. Some of or all of hydrogen atoms in the aryl group shown above may be replaced by fluorine atom(s).

In the formulas (1) and (2), at least one of R¹ and R² is the alkyl group shown above and at least one of R³ and R⁴ is the alkyl group shown above from the viewpoint of the solubility in organic solvents.

In the formulas (19) and (20), at least one of R²³ and R²⁴ is not a hydrogen atom. When both R²³ and R²⁴ are a hydrogen atom, the solubility is unfavorably deteriorated.

In the formulas (1), (2), (19) and (20), each of R¹, R², R³, R⁴, R²¹, R²², R²³ and R²⁴ is preferably a straight or branched alkyl group having 5 to 20 carbon atoms from the viewpoint of improving the charge transportability as an organic semiconductor, and all of the R¹ to R⁴ and R²¹ to R²⁴ are more preferably the alkyl group. R¹ and R² as well as R²¹ and R²² are preferably a branched alkyl group from the viewpoint of improving the solubility.

In the repeating units A and C, 2 or 3 structural units represented by the formula (3) are preferably contiguously present, more preferably form a structural unit represented by formula (7) or (8) shown below, and further preferably form the structural unit represented by the formula (7) shown below, from the viewpoint of improving the charge transportability.

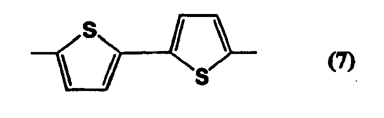

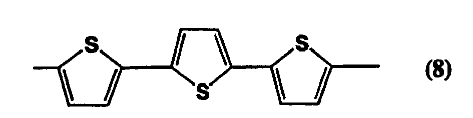

Furthermore, the structural unit represented by the formula (3) is preferably linked to at least one, in particular, both of bonds in the structural units represented by the formulas (2) and (19) from the viewpoint of increasing the planarity of the structure linked to structural units represented by the formulas (2) and (19).

From the above viewpoints, in the repeating units A and C, structural units represented by the formulas (2) and (20) and the structural unit represented by the formula (3) are preferred to together form structural units represented by the formula (9) and (22): 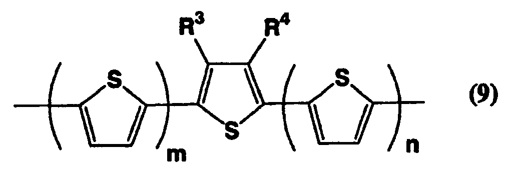 wherein R³ and R⁴ have the same meanings as shown above, each of m and n independently represents an integer from 1 to 3, provided that the sum of m and n is an integer from 3 to 6; 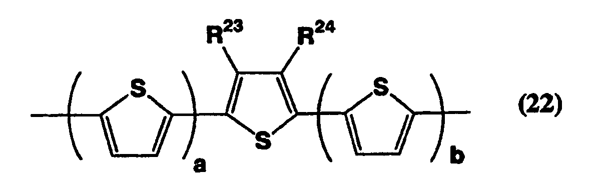 wherein R²³ and R²⁴ have the same meanings as shown above, and each of m and n independently represents an integer from 1 to 3, provided that the sum of a and b is an integer from 3 to 6.

In the formulas (9) and (22), m, n, a and b each independently represent an integer preferably of 2 or 3, and each of the sum of m and n as well as a and b is an integer more preferably from 4 to 6.
Furthermore, m and n as well as a and b, respectively, are preferred to be the same each other.

The polymer of the invention preferably contains a repeating unit that has a structure where the structural unit represented by the formula (2) and the structural unit represented by the formula (3) are linked by 4 or more in total, and more preferably contains a repeating unit that has a structure where the structural unit represented by the formula (2) and the structural unit represented by the formula (3) are linked by 5 or more, from the viewpoint of increasing the planarity when the structural units represented by the formulas (2) and (20) and the structural unit represented by the formula (3) are linked. When the planarity is increased thus, the packing between molecules is heightened, an interaction between molecules is heightened, and thereby the charge transportability is improved. On the other hand, the structural unit represented by the formula (3) is preferably not linked by 4 or more in the repeating units A and C, from the viewpoint of increasing the solubility of the polymer of the invention in organic solvents.

Furthermore, the polymer of the invention preferably has the repeating unit A where the structural unit represented by the formula (3) is linked to at least one and, in particular, to both of bonds in the structural unit represented by the formula (1), from the viewpoint of increasing the planarity between the structural unit represented by the formula (1) and the structure linked therewith.

In the polymer of the invention, the repeating units A and C may be contained singly or in a combination of at least two kinds thereof. The polymer of the invention preferably contains at least one of repeating units comprising one structural unit represented by the formula (1) and one structural unit represented by the formula (9).

Specific examples of the structural units represented by the formulas (9) and (22) include those represented by formulas (I) to (V) shown below, and those represented by a formula (II) shown below are preferred from the viewpoint of increasing the charge transportability. In the specific examples, those where R³ and R⁴ are an alkyl group are preferred: 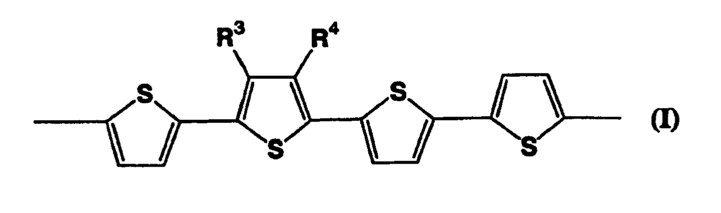 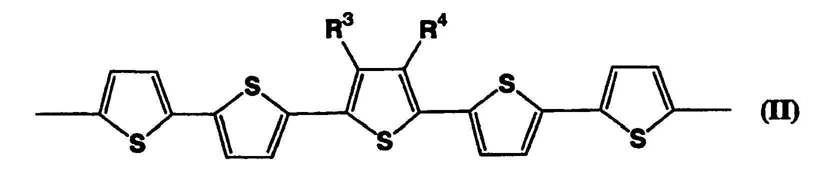 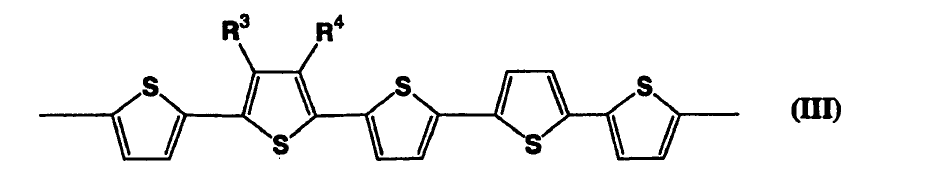 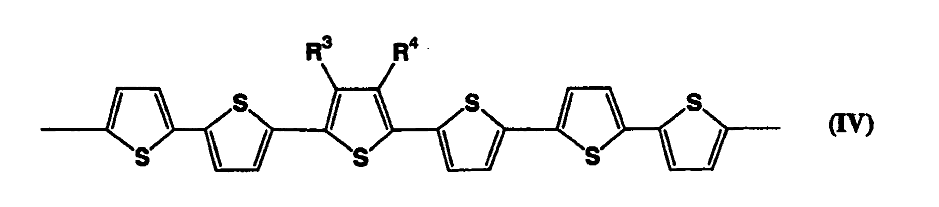 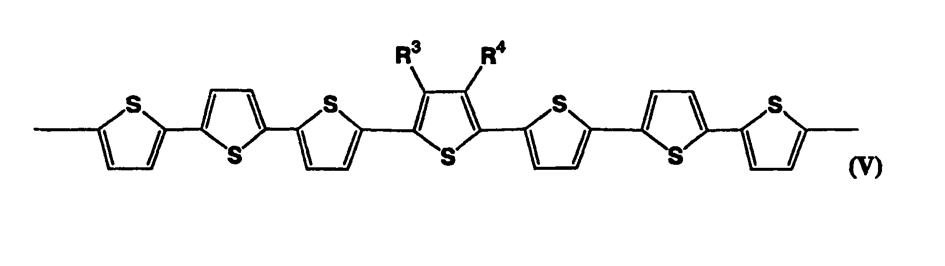 wherein R³ and R⁴ have the same meanings as shown above; 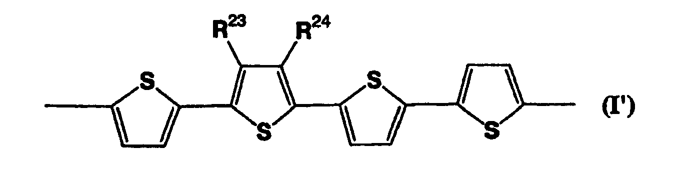 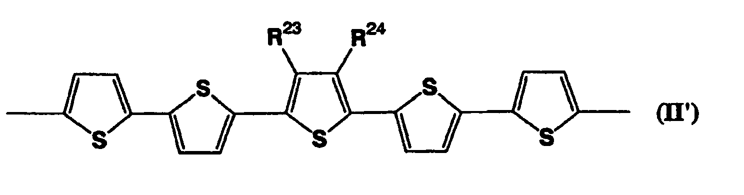 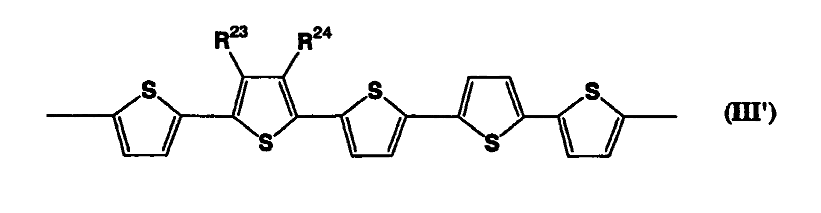 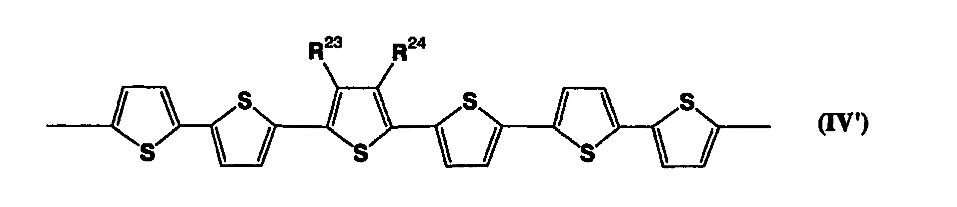 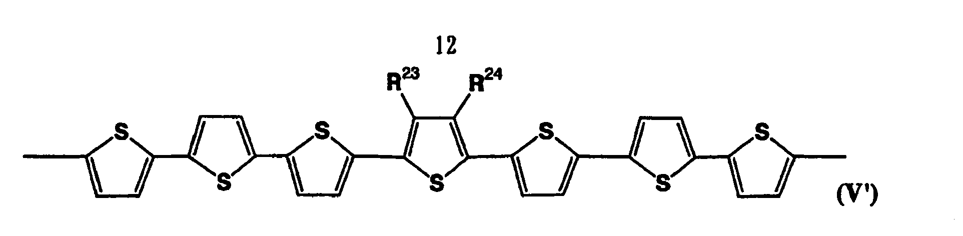 wherein R²³ and R²⁴ have the same meanings as shown above.

Furthermore, the first polymer of the invention may contain a repeating unit other than the repeating unit A. That is, the first polymer of the invention preferably further contains a repeating unit comprising one structural unit represented by a formula (10) shown below, one structural unit represented by a formula (11) shown below and at least one structural unit represented by a formula (3) (repeating unit B) (however, the repeating unit B is different from the repeating unit A), from the viewpoint of increasing the solubility in organic solvents and the charge transportability. On the other hand, the first polymer of the invention preferably contains only the repeating unit comprising structural units represented by the formulas (1) to (3), in view of the easiness in the production. Furthermore, in the polymer of the invention, the repeating units B may be contained singly or in a combination of at least two kinds thereof. 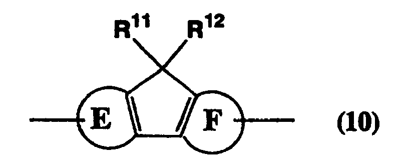 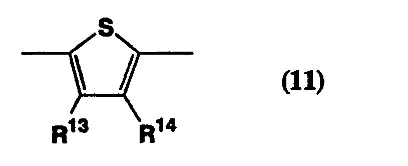 wherein an E ring and an F ring each independently represent an optionally substituted benzene ring or an optionally substituted naphthalene ring and have a bond on the optionally substituted benzene ring or on the optionally substituted naphthalene ring; R¹¹, R¹², R¹³ and R¹⁴ each independently represent a hydrogen atom, an alkyl group having 1 to 20 carbon atoms, an alkoxy group having 1 to 20 carbon atoms or an aryl group having 6 to 60 carbon atoms, where some of or all of hydrogen atoms in the groups may be replaced by fluorine atom(s) and the aryl group may be optionally substituted; provided that at least one of R¹³ and R¹⁴ is not a hydrogen atom; provided that when the E ring and F ring are a benzene ring and any one of R¹¹ and R¹² is an alkyl group, a difference between a maximum carbon number of a carbon main chain contained in the alkyl group represented by R¹¹ or R¹² and a maximum carbon number of a carbon main chain contained in an alkyl group represented by R¹³ or R¹⁴ is 2 or more.

Furthermore, the second polymer of the invention may further contain a repeating unit other than the repeating unit C. That is, the second polymer of the invention preferably contains a repeating unit comprising one structural unit represented by a formula (23) shown below, one structural unit represented by a formula (24) shown below and at least one structural unit represented by the formula (3) (repeating unit D), from the viewpoint of increasing the solubility in organic solvents and the charge transportability. On the other hand, the second polymer of the invention preferably contains only the repeating unit comprising structural units represented by the formulas (19), (20) and (3), in view of the easiness in the production. Furthermore, in the polymer of the invention, the repeating units B may be contained singly or in a combination of at least two kinds thereof. 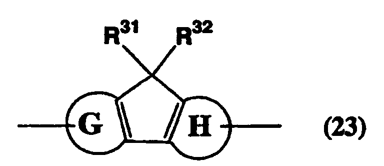 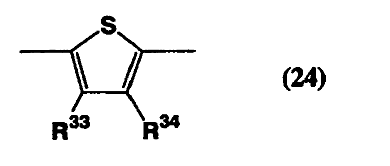 wherein a G ring and an H ring each independently represent an optionally substituted benzene ring and have a bond on the benzene ring that may have the substituent; R²¹, R²², R²³ and R²⁴ each independently represent a hydrogen atom, an alkyl group having 1 to 20 carbon atoms, an alkoxy group having 1 to 20 carbon atoms or an aryl group having 6 to 60 carbon atoms,
where some of or all of hydrogen atoms in the groups may be replaced by fluorine atom(s) and the aryl group may be optionally substituted.

In the optionally substituted benzene rings represented by the E ring, the F ring, the G ring and the H ring and optionally substituted naphthalene rings in the formula (10), examples of the substituents are the same as those described in a section of the optionally substituted benzene ring represented by the A ring, the B ring, the C ring and the D ring.

In the formulas (10), (11), (23) and (24), examples of alkyl groups having 1 to 20 carbon atoms, alkoxy groups having 1 to 20 carbon atoms and aryl groups having 6 to 60 carbon atoms, all of which are represented by R¹¹, R¹², R¹³ and R¹⁴ and R³¹, R³², R³³ and R³⁴ are the same as those described in the sections of alkyl groups having 1 to 20 carbon atoms, alkoxy groups having 1 to 20 carbon atoms and aryl groups having 6 to 60 carbon atoms, all of which are represented by R¹, R², R³ and R⁴. Furthermore, the alkyl group includes cyclic alkyl groups. Examples of the cyclic alkyl group include a cyclopropyl group, a cyclobutyl group, a cyclopentyl group, a cyclohexyl group, a cycloheptyl group, a cyclooctyl group, a cyclononyl group, a cyclododecyl group and so on.

When the polymer of the invention contains the repeating units (that is, other repeating units such as repeating units B and D), each of ratios of the repeating unit A and C to a whole repeating units is preferably 50% by mol or more (50 to 100% by mol), more preferably more than 50% by mol, still more preferably 80% by mol or more (80 to 100% by mol) and particularly preferably 80 to 95% by mole.

Specific examples of the first polymers of the invention preferably include those that contain a repeating unit represented by the formula (VI) shown below from the viewpoint of increasing the solubility in organic solvents and charge transportability. 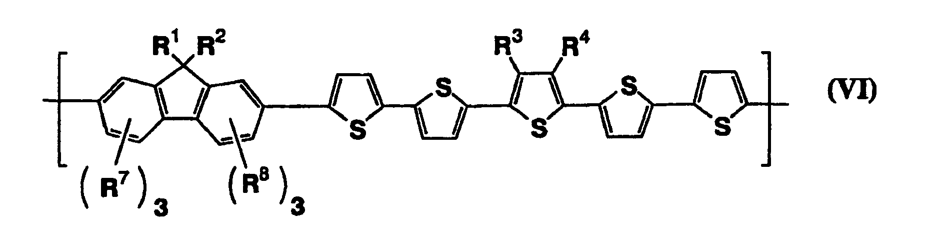 wherein R¹, R², R³ and R⁴ have the same meanings as shown above; R⁷ an R⁸ each independently represent a hydrogen atom, a straight or branched alkyl group having 1 to 20 carbon atoms, an alkoxy group having 1 to 20 carbon atoms or an aryl group having 6 to 60 carbon atoms; the aryl group may be optionally substituted; a plurality of R⁷ and R⁸ may be the same each other or different from each other.

In the formula shown above, examples of the straight or branched alkyl groups having 1 to 20 carbon atoms, alkoxy groups having 1 to 20 carbon atoms and aryl groups having 6 to 60 carbon atoms, all of which are represented by R⁷ and R⁸, are the same as those described in sections of straight or branched alkyl groups having 1 to 20 carbon atoms, alkoxy groups having 1 to 20 carbon atoms and aryl groups having 6 to 60 carbon atoms, all of which are shown in R¹, R², R³ and R⁴.

Specific examples of the second polymer of the invention preferably include those containing repeating units represented by a formula (VI') and/or a (VII') shown below, from the viewpoint of increasing the solubility in organic solvents and charge transportability. 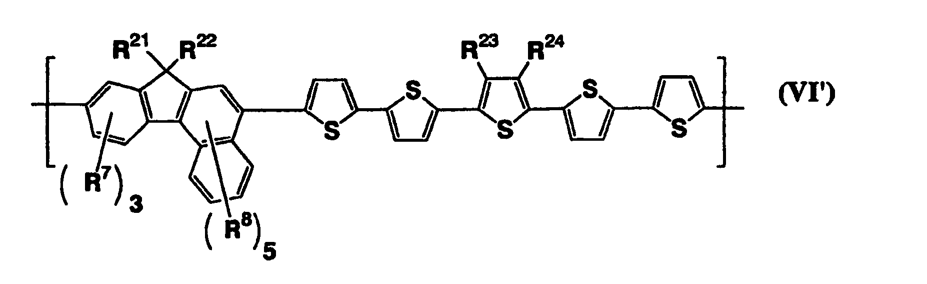 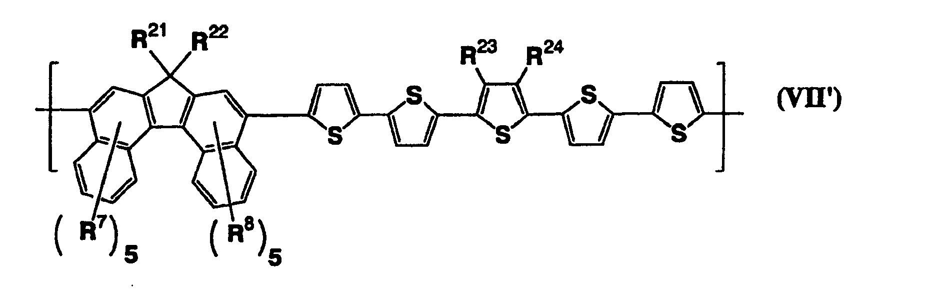 wherein R²¹, R²², R²³ and R²⁴ have the same meanings as shown above; R²¹ an R²³ each independently represent a hydrogen atom, a straight or branched alkyl group having 1 to 20 carbon atoms, an alkoxy group having 1 to 20 carbon atoms or an aryl group having 6 to 60 carbon atoms; the aryl group may be optionally substituted; a plurality of R²¹ and R²³ may be the same each other or different from each other.

In the case where the polymer of the invention is used to produce an organic photoelectric conversion device, when a polymerization active group remains per se on a terminal group, performance such as the durability and so on of a resulted device may be deteriorated; accordingly, it is preferable to protect the terminal group by a stable group.

Examples of the terminal group include a hydrogen atom, an alkyl group, an alkoxy group, a fluoroalkyl group, a fluoroalkoxy group, an aryl group, a heterocyclic group, an electron donating group, an electron accepting group and so on. An arylamino group or an electron donating group is preferred from the viewpoint of increasing the hole transportability. Furthermore, as the terminal group, those having a conjugated bond continual with a conjugated structure of a main chain are preferred. For example, those that bond via a carbon-carbon bond with an aryl group or a heterocyclic group are cited.

As the first polymer of the invention, those represented by formulas (X) to (XVII) shown below are particularly preferred. 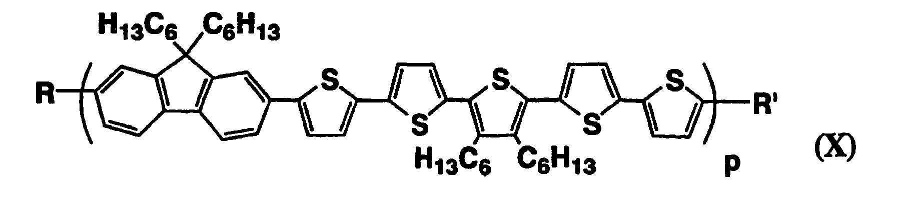 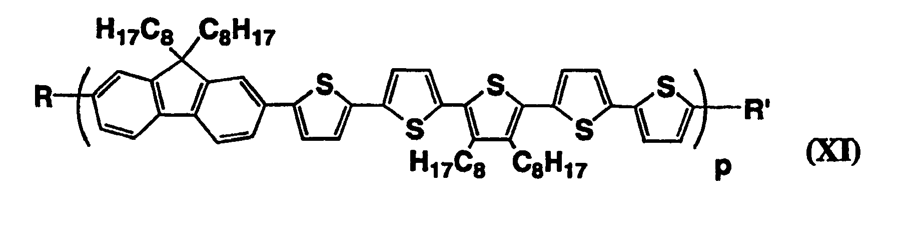 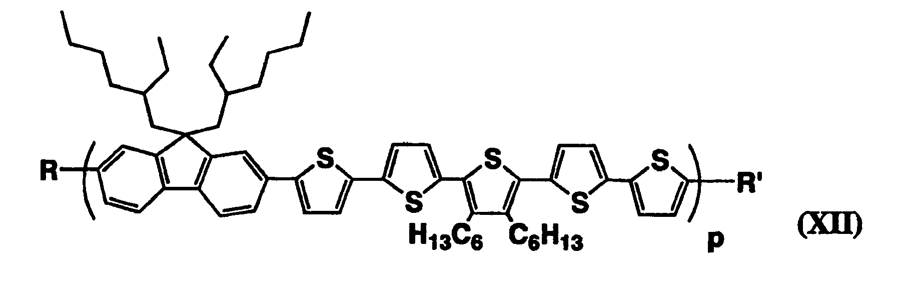 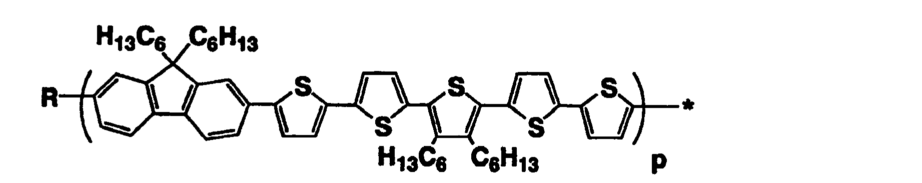 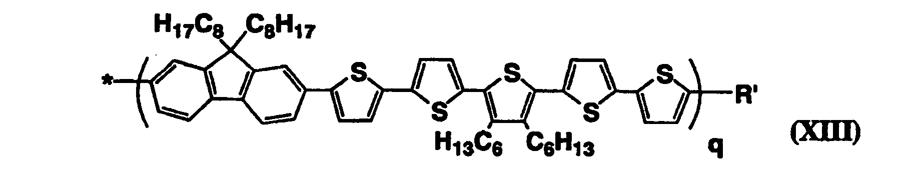 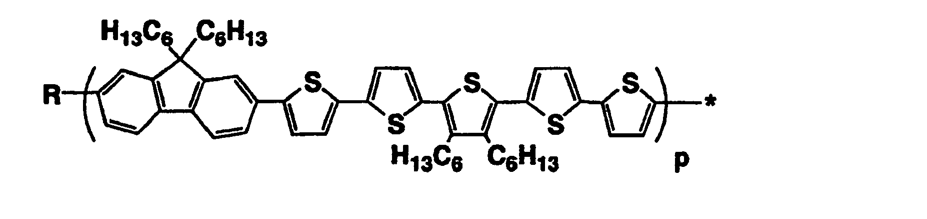 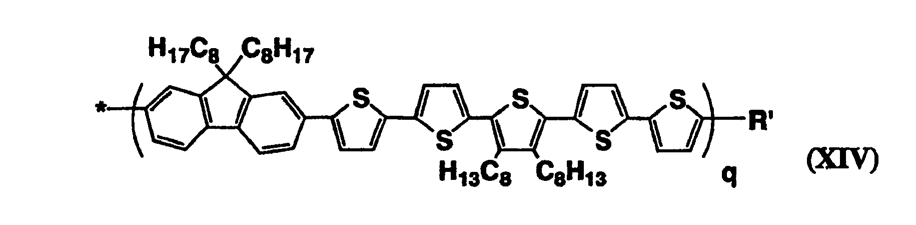 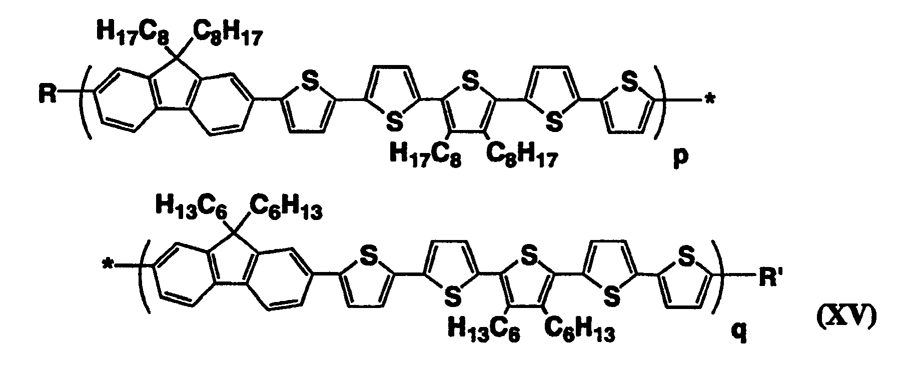 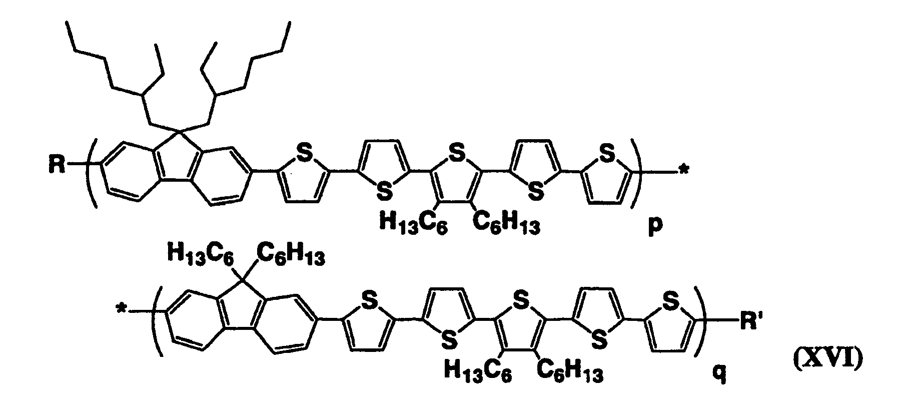 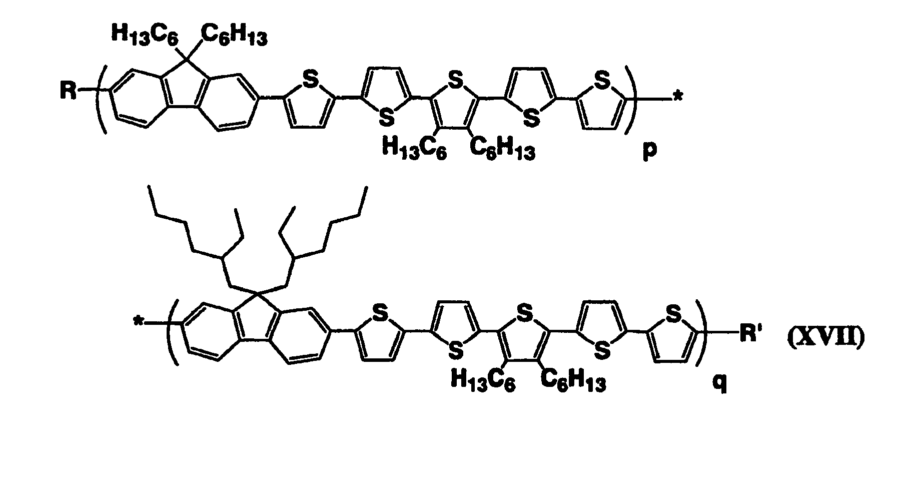 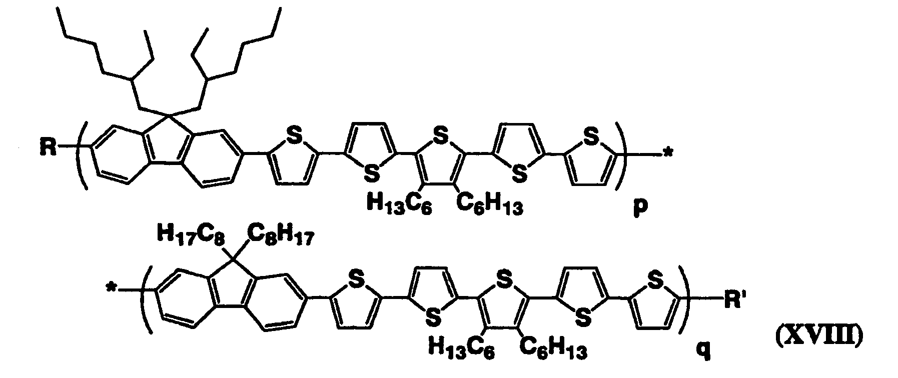 wherein R and R' each independently represent a terminal group; P and q each independently represent an integer from 2 to 10000; P and q are preferably an integer from 2 to 9 when a compound represented by the formula is an oligomer, and preferably an integer from 10 to 2000 and particularly preferably an integer from 10 to 200 when the compound represented by the formula is a polymer; and the respective formulas, two * marks mean a state of mutual bonding; 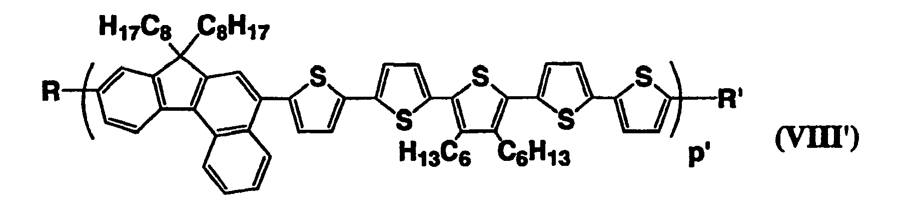 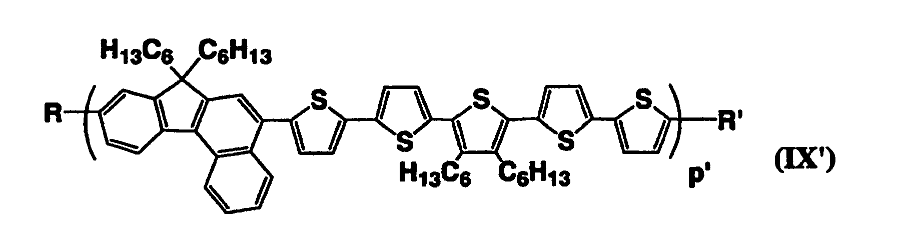 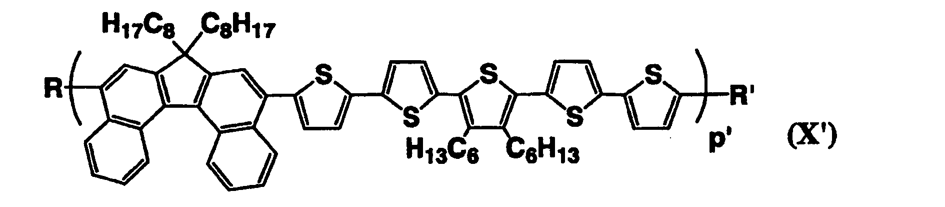 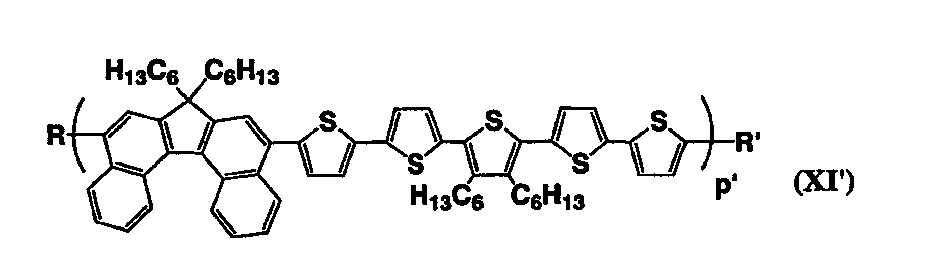 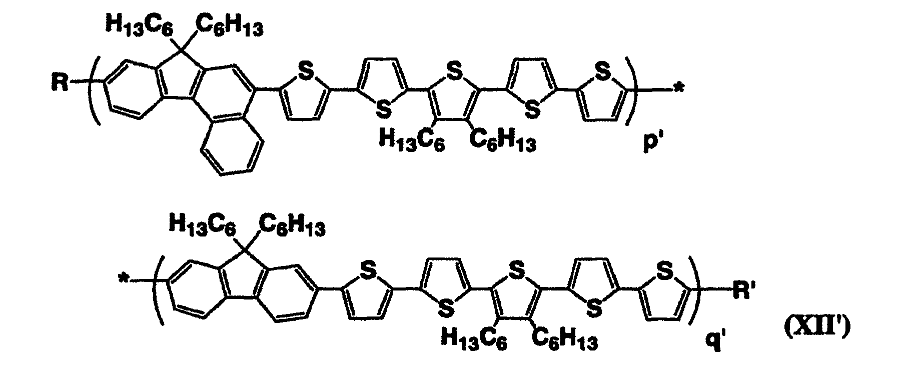 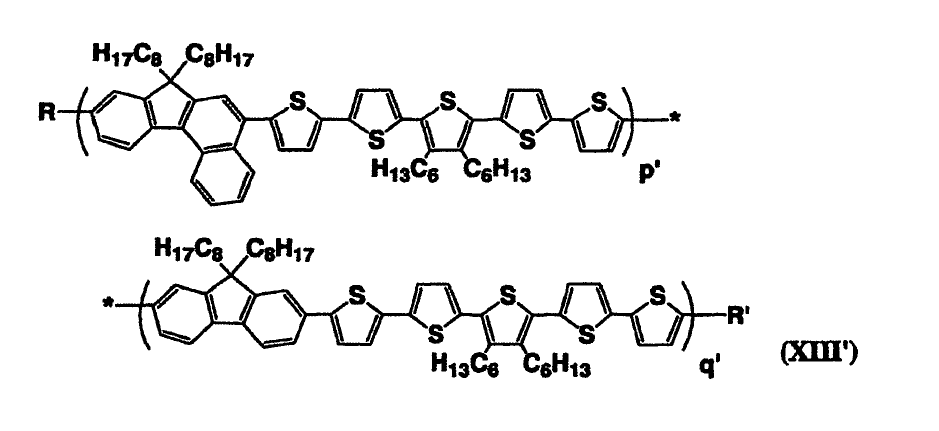 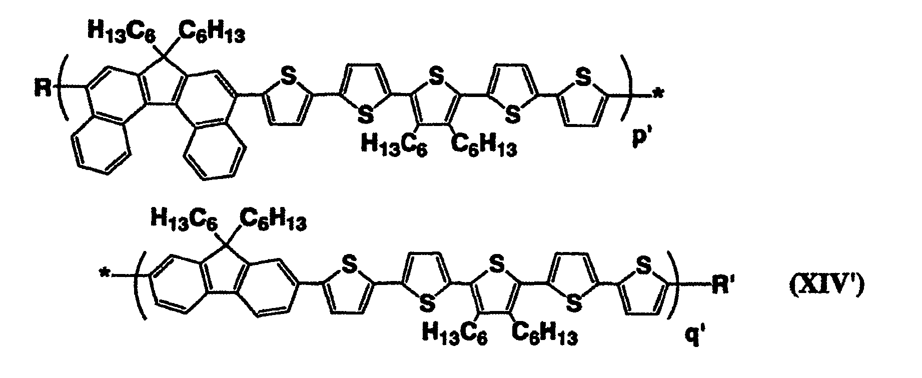 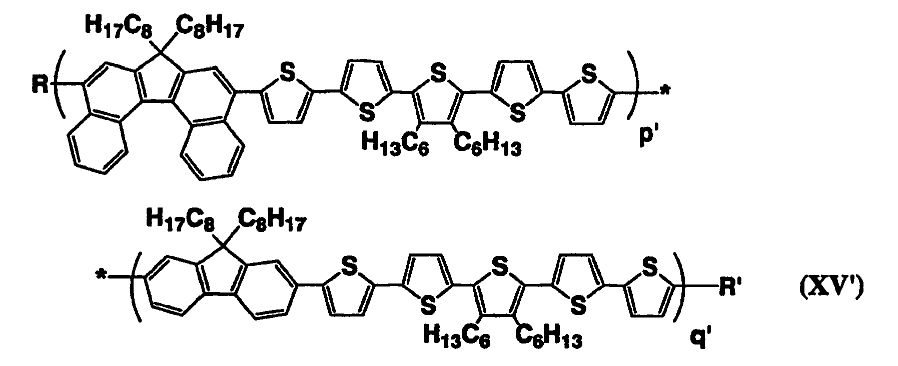 wherein R and R' each independently represent a terminal group; P' and q' each independently represent an integer from 2 to 10000; P' and q' are preferably an integer from 2 to 9 when a compound represented by the formula is an oligomer, and preferably an integer from 10 to 2000 and particularly preferably an integer from 10 to 200 when the compound represented by the formula is a polymer; in the respective formulas, two * marks mean a state of mutual bonding.

In the formulas, the terminal groups represented by R and R' have the same meanings as shown above, and a phenyl group, an arylamino group and an electron donating group are preferred.

A number average molecular weight in terms of polystyrene of the first polymer of the invention is preferably 10³ to 10⁸, more preferably 10³ to 10⁶ and still more preferably 10³ to 10⁵.

A number average molecular weight in terms of polystyrene of the second polymer of the invention is preferably 10³ to 10⁸, more preferably 10³ to 10⁶ and still more preferably 10³ to 10⁵.

### <Producing Method of Polymer>

A producing method of a polymer of the invention may be any one of producing methods thereof without restricting to particular one. However, a producing method shown below is preferably used to produce.

A first polymer of the invention can be produced by reacting those selected from compounds represented by formulas (13) to (18) shown below depending on a kind of a target polymer (for example, a combination of formulas (13) to (15) shown below, a combination of formulas (16) to (18) shown below or the like). 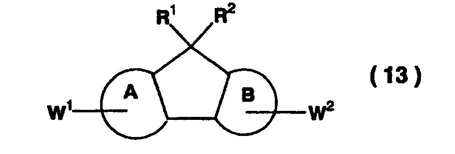 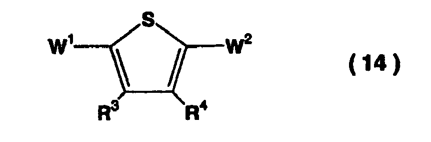 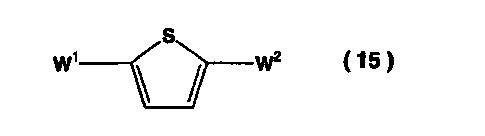 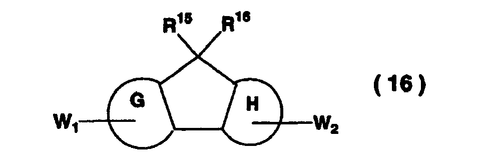 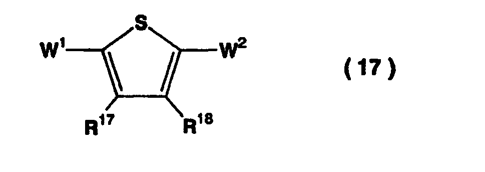 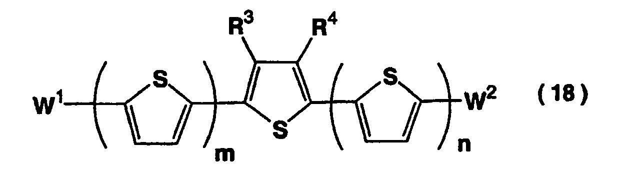 wherein an A ring, a B ring, a G ring and an H ring, R¹ to R⁴, R¹⁵ to R¹⁸, m and n have the same meanings as shown above; W¹ and W² each independently represent a halogen atom, an alkylsulfonate group, an arylsulfonate group, an arylalkylsulfonate group, a boric ester-residue, a sulfonium methyl group, a phosphonium methyl group, a phosphonate methyl group, a monohalogenated methyl group, a boric acid residue (-B(OH)₂), a formyl group or a vinyl group.

W¹ and W² each are independently preferred to be a halogen atom, an alkylphosphonate group, an arylsulfonate group, an arylalkylsulfonate group, a boric ester-residue or a boric acid residue, from the synthetic point of view of compounds represented by the formulas (13) to (18) and the viewpoint of easiness of the reaction.

The second polymer of the invention can also be produced in the same manner as that described above.

The boric acid ester residue includes, for example, groups shown by formulas below.

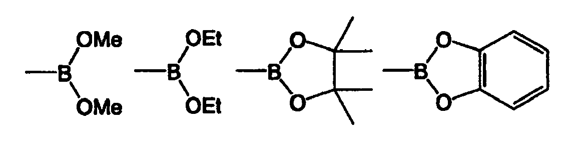

Examples of a reaction method used in the synthesis of the polymer of the invention include a method that uses a Suzuki coupling reaction, a method that uses a Grignard reaction, a method that uses a Stille reaction, a method that uses a Ni (0) catalyst, a method that uses an oxidizing agent such as FeCl₃ or the like, a method that uses an electrochemical oxidation reaction, a method where an intermediate compound having an appropriate elimination group is decomposed, and so on. Among these methods, a polymerization method that uses a Suzuki coupling reaction, a method that uses a Grignard reaction, a method that uses a Stille reaction and a method that uses a Ni (0) catalyst are preferred because a structural control is easy, and a method that uses a Suzuki coupling reaction, a method that uses a Grignard reaction and a method that uses a Stille reaction are particularly preferred because of easy availability of raw materials and easiness of reaction operation.

In the reactions, an alkali or an appropriate catalyst may be added to promote a reaction. The alkali or appropriate catalyst may be selected depending on a kind of reaction and is preferred to be one that is sufficiently dissolved in a solvent used in the reaction.

In the case where the polymer of the invention is used as a material for organic thin film devices, the purity thereof affects on device performance. Accordingly, it is preferred that a monomer before the reaction is purified by a method such as distillation, sublimation purification, recrystallization or the like, followed by polymerizing (reacting), and that, after the synthesis, a purification treatment such as reprecipitation purification, fractionation by chromatography or the like is applied.

Examples of solvent used in the reaction include saturated hydrocarbons such as pentane, hexane, heptane, octane and cyclohexane, unsaturated hydrocarbons such as benzene, toluene, ethyl benzene and xylene, halogenated saturated hydrocarbons such as carbon tetrachloride, chloroform, dichloromethane, chlorobutane, bromobutane, chloropentane, bromopentane, chlorohexane, bromohexane, chlorocyclohexane and bromocyclohexane, halogenated unsaturated hydrocarbons such as chlorobenzene, dichlorobenzene and trichlorobenzene, alcohols such as methanol, ethanol, propanol, isopropanol, butanol and t-butyl alcohol, carboxylic acids such as formic acid, acetic acid and propionic acid, ethers such as dimethyl ether, diethyl ether, methyl-t-butyl ether, tetrahydrofuran, tetrahydropyrane and dioxane, and inorganic acids such as hydrochloric acid, bromic acid, hydrofluoric acid, sulfuric acid and nitric acid. The solvents may be used singly or in a combination of at least two kinds thereof.

After the reaction, an ordinary posttreatment such as the treatment including quenching the reaction mixture by water, extracting by organic solvent and distilling off the solvent can be applied to obtain. Isolation and purification of a product are conducted by a method such as fractionation by chromatography, recrystallization and so on.

### <Composition>

A composition of the invention contains a polymer of the invention. The composition of the invention may contain, other than the polymer, an electron donor compound, an electron acceptor compound, a polymer other than the polymer of the invention, a solvent, an additive and so on. In the composition of the invention, a ratio of the polymer of the invention in a total solid content is usually 10 to 90% by weight.

### <Organic Photoelectric Conversion Device>

An organic photoelectric conversion device of the invention is not particularly restricted as long as it has a pair of electrodes at least one of which is transparent or semitransparent, and a layer that is disposed between the electrodes and has a hetero-junction where an electron acceptor compound and an electron donor compound are disposed adjacent each other. Specifically, any one of the followings is preferred. That is,
1. an organic photoelectric conversion device that includes a pair of electrodes at least one of which is transparent or semitransparent, a first organic layer that is disposed between the electrodes and contains an electron acceptor compound, and a second organic layer disposed adjacent to the first organic layer and containing an electron donor compound, wherein the electron donor compound is the polymer shown above, and
2. an organic photoelectric conversion device that includes a pair of electrodes at least one of which is transparent or semitransparent, and at least one layer of an organic layer disposed between the electrodes and containing an electron acceptor compound and an electron donor compound, wherein the electron donor compound is the polymer shown above.

In the next place, an operation mechanism of the organic photoelectric conversion device will be described. Light energy inputted from a transparent or semitransparent electrode is absorbed by an electron acceptor compound and/or an electron donor compound to generate excitons where electrons and holes are bonded. When the generated excitons move and reach a hetero-junction interface where the electron acceptor compound and the electron donor compound are adjacent, electrons and holes are separated because of difference of energies of the respective HOMO (Highest Occupied Molecular Orbit) and LUMO (Lowest Occupied Molecular Orbit) at the interface and generate charges (electrons and holes) capable of independently moving. The generated charges respectively move to the electrodes and are taken outside as electric energy (current).

In order to realize a high conversion efficiency of an organic photoelectric conversion device, it is important that an electron acceptor compound and/or an electron donor compound has an absorption region capable of efficiently absorbing a desired spectrum of incident light, many hetero-junction interfaces are contained to efficiently separate excitons, and the charge transportability for speedily transporting generated charges to the electrodes is possessed.

From such viewpoints, an organic photoelectric conversion device of the invention is preferred to be the 1. or the 2. and, from the viewpoint of containing many hetero-junction interfaces, the 2. is more preferred. Furthermore, an organic photoelectric conversion device of the invention may be provided with an additive layer between at least one of the electrodes and an organic layer in the device. Examples of the additive layer include a charge transporting layer that transports holes or electrons, a buffer layer for isolating the electrodes and the organic layer, and so on.

Specifically, the organic photoelectric conversion device (1.) having a buffer layer between the first organic layer containing the electron acceptor compound and one of the electrodes, and the organic photoelectric conversion device (2.) having a buffer layer between the organic layer containing the electron acceptor compound and electron donor compound and one of the electrodes are preferred.

Furthermore, from the viewpoints of improving the photoelectric conversion efficiency and durability, the organic photoelectric conversion device of the invention may be provided with an anti-reflection layer for inhibiting incident light from reflecting, a UV absorbing layer for absorbing UV rays, a protective layer for protecting from air and so on at portions other than a portion between a pair of electrodes that are transparent or semitransparent such as a back surface of a substrate (that is, a surface where an electrode is not formed of a substrate), the inside of the substrate, a portion between the substrate and electrode, a top portion of an upper electrode (that is, an electrode formed on the organic layer), and the layers may be disposed singly or in a combination of at least two kinds thereof. Furthermore, the anti-reflection layer and UV-absorption layer are preferably disposed on a light-incident surface.

Examples of the UV absorbing layer include a resin containing a UV absorbent (detailed below), and a layer containing an inorganic UV absorbent such as ultrafine fine particles of titanium oxide (particle diameters are usually 0.01 µm to 0.06 µm), ultrafine particles of zinc oxide (particle diameters are usually 0.01 µm to 0.04 µm) or the like.

An organic photoelectric conversion device of the invention is usually formed on a substrate. The substrate may be any one as long as it does not change when the electrodes are formed and a layer of an organic material is formed. Examples of material of the substrate include glass, plastic, polymer film, silicon and so on. In the case of a non-transparent substrate, an opposite electrode (that is, an electrode remote from the substrate) is preferably transparent or semitransparent.

Examples of materials for the transparent or semitransparent electrode include electroconductive metal oxide films, semitransparent metal thin films and so on. Specifically, films (NESA and so on) made of indium oxide, zinc oxide, tin oxide, composite thereof such as indium tin oxide (ITO) and indium zinc oxide, which are made by the use of electroconductive glass, gold, platinum, silver, copper and so on, can be used. Among these, ITO, indium zinc oxide and tin oxide are preferred. Examples of preparation method of the electrode include a vacuum deposition method, a sputtering method, an ion plating method, a plating method and so on. Furthermore, as the electrode material, organic transparent electroconductive films made of polyaniline and derivatives thereof, polythiophene and derivatives thereof and so on may be used. Still furthermore, as the electrode material, metals, electroconductive polymer and so on may be used. One of the pair of electrodes is preferably made of a material small in the work function. For example, metals such as lithium, sodium, potassium, rubidium, cesium, magnesium, calcium, strontium, barium, aluminum, scandium, vanadium, zinc, yttrium, indium, cerium, samarium, europium, terbium, ytterbium and so on, alloys between at least two of these, alloys between one of these and at least one of gold, silver, platinum, copper, manganese, titanium, cobalt, nickel, tungsten and tin, graphite or graphite interlayer compounds and so on are used. Examples of alloys include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy and so on.

As materials used in the charge transporting layer as the additive layer, that is, a hole transporting layer and an electron transporting layer, an electron donor compound and an electron acceptor compound respectively described below may be used. As materials used in a buffer layer as the additive layer, halides, oxides and so on of alkali metals and alkaline earth metals such as lithium fluoride and so on can be used. Furthermore, fine particles of inorganic semiconductors such as titanium oxide and so on as well may be used.

As the buffer layer, those combining a role as a charge transporting layer are preferred, and materials that transports one charges (for example, electrons) but are difficult to transport the other charges (for example, holes) can be used. Preferable examples of such materials include arylamine derivatives such as CBP (4,4-di(N-carbazole)biphenyl) and so on, phenanthrene derivatives such as bathocuproine and so on and fullerene derivatives such as C₆₀ and so on. Among these, phenanthrene derivatives and fullerene derivatives are more preferred, phenanthrene derivatives are still more preferred, and bathocuproine are particularly preferred.

### <Organic Thin Film>

Examples of the organic layer (an organic layer containing a polymer of the invention) in an organic photoelectric conversion device of the invention include an organic thin film containing a polymer of the invention.

In the organic thin film, a film thickness is usually 1 nm to 100 µm, preferably 2 nm to 1000 nm, more preferably 5 nm to 500 nm and still more preferably 20 nm to 200 nm.

The organic thin film may contain one kind or at least two kinds of the polymers of the invention. Furthermore, a mixture of a low molecule compound and/or a polymer other than the polymer of the invention may be used as an electron donor compound and/or an electron acceptor compound in the organic thin film to increase the hole transportability of the organic thin film.

As the electron donor compound, known electron donor compounds may be used, and examples thereof include pyrazoline derivatives, arylamine derivatives, stilbene derivatives, triphenyldiamine derivatives, oligothiophene and derivatives thereof, polyvinyl carbazole and derivatives thereof, polysilane and derivatives thereof, polysiloxane derivatives having aromatic amine in a side chain or a main chain, polyaniline and derivatives thereof, polythiophene and derivatives thereof, polypyrrole and derivatives thereof, polyphenylenevinylene and derivatives thereof, polythienylenevinylene and derivatives thereof and so on.

As the electron acceptor compound, known electron acceptor compounds may be used, and examples thereof include oxadiazole derivatives, anthraquinodimethane and derivatives thereof, benzoquinone and derivatives thereof, naphtoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, 8-hydroxyquinoline and metal complexes of derivatives thereof, polyquinoline and derivatives thereof, polyquinoxaline and derivatives thereof, polyfluorene and derivatives thereof, fullerenes such as C₆₀ and so on and derivatives thereof, and phenanthrene derivatives such as bathocuproine and so on. Among these, compounds selected from a group consisting of fullerene (for example, C₆₀ and so on) and derivatives thereof are preferred from the viewpoints of easy separability from excitons (electron-hole pair) into charges in a hetero-junction surface with a polymer of the invention and the transportability of separated electrons. Fullerene derivatives are more preferred. As the fullerene derivatives, those soluble by 10 parts by weight or more in 90 parts by weight of dichlorobenzene (that is, halogenated organic solvent), for example, PCBM (Phenyl C61-butyric acid methyl ester), PCBIB (Phenyl C61-butyric acid i-butyl ester) and so on, or those soluble by 10 parts by weight or more in 90 parts by weight of xylene (that is, a hydrocarbon organic solvent) for example, PCBNB (Phenyl C61-butyric acid n-butyl ester) and so on, are particularly preferred.

In the organic photoelectric conversion device of the invention, an organic thin film containing a polymer of the invention is preferably used as the electron donor compound, and the organic thin film may contain the electron acceptor compound shown above.

The organic thin film may contain materials necessary for developing various functions. For example, a sensitizer for sensitizing a function of generating charges with absorbed light, an anti-oxidizing agent for inhibiting an oxidation from occurring, a light stabilizer for increasing the stability, a UV absorbent for absorbing UV rays and so on are cited. When a polymer of the invention is used together with the anti-oxidizing agent and/or the UV absorbent, the UV resistance of a resulted mixture (composition) is improved. Accordingly, when the mixture (composition) is applied to an organic photoelectric conversion device, the UV resistance of the device becomes excellent.

Examples of the anti-oxidant include hindered phenol compounds, phosphite compounds and so on. These may be used singly or in a combination of at least two kinds thereof.

Examples of the light stabilizer include such as benzophenone compounds, benzotriazole compounds, cyanoacrylate compounds, oxalic acid compounds, hindered amine compounds, salicylic acid ester compounds, hydroxy benzoate compounds, benzoate compounds, carbamate compounds and so on. These compounds may be used singly or in a combination of at least two kinds thereof.

Examples of the UV absorbent include salicylic acid ester compounds, benzophenone compounds, benzotriazole compounds, hydroxy benzoate compounds, benzoate compounds, cyanoacrylate compounds, carbamate compounds and so on, and these compounds may be used singly or in a combination of at least two kinds thereof. The anti-oxidizing agent, light stabilizer and UV absorbent may be used in a combination of at least two kinds thereof, and it is effective that each thereof is effectively compounded at a ratio of 5 parts by weight or less and particularly at a ratio from 0.1 to 3 parts by weight relative to 100 parts by weight of the polymer of the invention.

The organic thin film may contain, other than the polymer of the invention, a polymer compound as a polymer binder to increase the mechanical characteristics. As the polymer binder, those that do not extremely disturb the electron transportability or hole transportability are preferred and those that are not so strong in the absorption of visible light are preferred.

Examples of the polymer binder include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and so on.

A producing method of the organic thin film is not particularly restricted. For instance, a method where a film is formed from a solution containing the polymer of the invention is cited and a method of forming a thin film by use of a vacuum deposition method as well may be used.

The solvent used when a film is formed from a solution is not restricted to particular one as long as it dissolves the polymer of the invention. Examples of the solvent include unsaturated hydrocarbon solvents such as toluene, xylene, mesitylene, tetralin, decalin, bicyclohexyl, n-butylbenzene, sec-butylbenzene, tert-butylbenzene and so on, halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane and so on, halogenated unsaturated hydrocarbon solvents such as chlorobenzene, dichlorobenzene, trichlorobenzene and so on, and ethers solvents such as tetrahydrofuran, tetrahydropyrane and so on. The polymer of the invention can be usually dissolved by 0.1% by weight or more in the solvent.

When a film is formed from a solution, a coating method such as a spin coat method, a casting method, a micro-gravure coat method, a gravure coat method, a bar coat method, a roll coat method, a wire bar coat method, a dip coat method, a spray coat method, a nozzle coat method, a cap coat method, a screen printing method, a flexo printing method, an offset printing method, an inkjet printing method, a dispenser printing method or the like may be used. Among these a spin coat method, a nozzle coat method, a cap coat method, a flexo printing method, an inkjet printing method and a dispenser printing method are preferred.

The organic thin film shown above may include in a producing step thereof a step of orienting a polymer of the invention. In an organic film where the polymer of the invention is oriented according to the step, main chain molecules or side chain molecules are oriented in one direction; accordingly, the electron mobility or hole mobility is improved.

As a method of orienting the polymer of the invention, methods known as an orienting method of liquid crystal can be used. Among these, a rubbing method, an optical orientation method, a shearing method (shearing stress application method), a pulling-up coating method and so on are convenient, useful and easy to use as the orienting method. A rubbing method and a shearing method are preferred.

The organic thin film has the electron transportability or hole transportability; accordingly, when electrons or holes injected from an electrode or charges generated by absorbing light are transported and controlled, the organic thin film may be used in various organic thin film devices such as organic electroluminescent devices, organic transistors, organic solar batteries, optical sensors and so on. In the case where the organic thin film is used in the organic thin film devices, when the organic thin film is oriented by an orientation treatment and used, the electron transportability or hole transportability is more preferably improved.

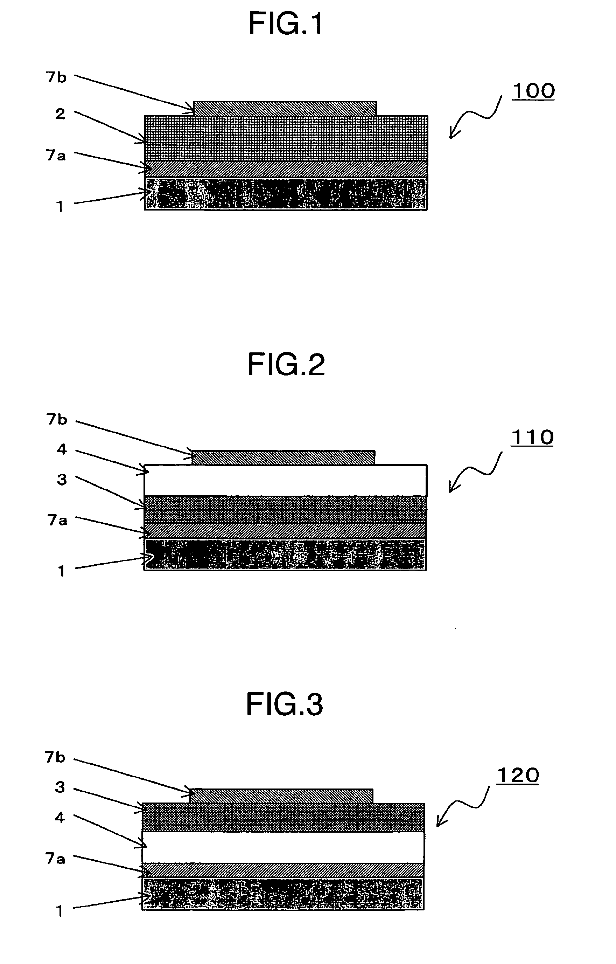

Fig. 1 is a schematic view of an organic photoelectric conversion device involving a first embodiment. In Fig. 1, an organic photoelectric conversion device 100 is formed by including: a substrate 1; a first electrode 7a formed on the substrate 1; an organic layer 2 that is formed on the first electrode 7a on a side opposite to the substrate 1 and contains a polymer of the invention as an electron donor compound and an electron acceptor compound; and a second electrode 7b formed on the organic layer 2 on a side opposite to the first electrode 7a so as to partially cover the organic layer 2.

Fig. 2 is a schematic view of an organic photoelectric conversion device involving a second embodiment. In Fig. 2, an organic photoelectric conversion device 110 is formed by including: a substrate 1; a first electrode 7a formed on the substrate 1; an organic layer 3 that is formed on the first electrode 7a on a side opposite to the substrate 1 and contains a polymer of the invention as an electron donor compound; an organic layer 4 that is formed on the organic layer 3 on a side opposite to the first electrode 7a and contains an electron acceptor compound; and a second electrode 7b formed on the organic layer 4 on a side opposite to the organic layer 3 so as to partially cover the organic layer 4.

Fig. 3 is a schematic view of an organic photoelectric conversion device involving a third embodiment. In Fig. 3, an organic photoelectric conversion device 120 is formed by including: a substrate 1; a first electrode 7a formed on the substrate 1; an organic layer 4 that is formed on the first electrode 7a on a side opposite to the substrate 1 and contains an electron acceptor compound; an organic layer 3 that is formed on the organic layer 4 on a side opposite to the first electrode 7a and contains a polymer of the invention as an electron donor compound; and a second electrode 7b formed on the organic layer 3 on a side opposite to the organic layer 4 so as to partially cover the organic layer 3.

In the organic photoelectric conversion device involving an embodiment of the invention, a transparent or semitransparent electrode is used in one of the first electrode 7a and second electrode 7b. The electrode material is, as mentioned above, for example, a metal such as aluminum, gold, silver, copper, alkali metal, alkaline earth metal or the like. In order to obtain high open voltage, the respective electrodes are preferably selected so that difference of the work functions thereof may be larger. Examples of the material of the substrate 1 include, as mentioned above, silicon, glass, plastic, a metal foil and so on. Other constituent elements are the same as those shown above.

In an organic photoelectric conversion device involving the embodiment of the invention, when light such as solar light or the like is illuminated from a transparent or semitransparent electrode, an optical electromotive force is generated between the first electrode 7a and the second electrode 7b, and thereby the organic photoelectric conversion device may be operated as an organic thin film solar battery. When a plurality of organic thin film solar batteries is stacked, the stacked one may be used as well as an organic thin film solar battery module.

Furthermore, in an organic photoelectric conversion device involving the embodiment of the invention, a photocurrent flows when light is illuminated from a transparent or semitransparent electrode with a voltage applied between the first electrode 7a and second electrode 7b. Accordingly, the organic photoelectric conversion device may be operated as well as an organic photodetector. When a plurality of organic photodetectors is stacked, the stacked one may be used as well as an organic image sensor.

### <Applications of Device>

When a plurality of organic photoelectric conversion devices of the invention is stacked, an organic thin film solar battery module and an organic image sensor can be formed. That is, an organic thin film solar battery module and an organic thin film solar battery module of the invention are formed by stacking a plurality of organic photoelectric conversion devices of the invention.

In what follows, the present invention will be more specifically described with reference to examples and comparative examples. However, the invention is not restricted thereto.

### (Number Average Molecular Weight)

In Examples described below, a number average molecular weight of a polymer was obtained by gel permeation chromatography (GPC, trade name: LC-10Avp, manufactured by Shimadzu Corporation) as a number average molecular weight in terms of polystyrene. A polymer to be measured was dissolved in tetrahydrofuran so as to be a concentration of substantially 0.5% by weight and 50 µL thereof was charged in the GPC. As a mobile phase of the GPC, tetrahydrofuran was used and flowed at a flow rate of 0.6 mL/min. As a column, two of TSKgel Super HM-H (manufactured by Tosoh Corporation) and one of TSKgel Super H2000 (manufactured by Tosho Corporation) were connected in series. A differential refractometer (trade name: RID-10A, manufactured by Shimadzu Corporation) was used as a detector.

### <Example 1>

With 9,9-dihexylfluorene-2,7-diboric acid ester (8.012 g, 0.017 mol) and 5,5''''-3'',4''-dihexyl-α-pentathiophene (13.16 g, 0.018 mol), according to a method described in WO2005/092947, 12.21 g of a pentathienyl-fluorene copolymer (hereinafter, referred to as "polymer A") represented by a formula shown below was synthesized. The number average molecular weight in terms of polystyrene of the polymer A was 4.5 × 10⁴. 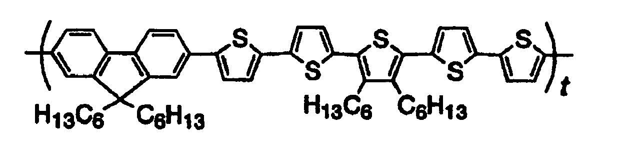 (In the formula, t represents a degree of polymerization.)

### <Reference Synthesis Example 1>

With 9,9-dioctylfluorene-2,7-diboric acid ester (1.06 g, 2.25 mmol) and 5,5''''-3'',4''-dihexyl-α-pentathiophene (1.48 g, 2.02 mmol), according to a method described in WO2005/092947, 1 g of a pentathienyl-fluorene copolymer (hereinafter, referred to as "polymer B") represented by a formula shown below was synthesized. The number average molecular weight in terms of polystyrene of the polymer B was 6.1 × 10⁴.
(In the formula, t represents a degree of polymerization.)

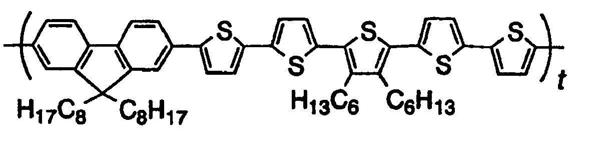

### <Example 2>

With 9,9-dihexylfluorene-2,7-diboric acid ester (0.986 g, 2.079 mmol), 9,9-dioctylfluorene-2,7-diboric acid ester (0.276 g, 0.520 mmol) and 5,5''''-3'',4''-dihexyl-a-pentathiophene (2.024 g, 2.707 mmol), according to a method described in WO2005/092947, 2.03 g of a polymer C having the repeating units at a ratio represented by a formula shown below was synthesized. The number average molecular weight in terms of polystyrene of the polymer C was 3.2 × 10⁴.

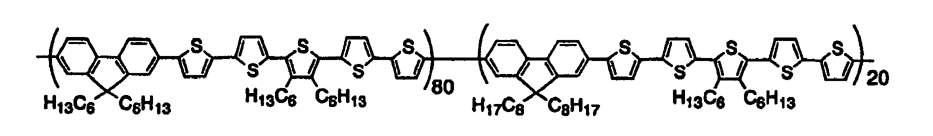

### <Example 3>

### · Preparation of Organic Photoelectric Conversion Device

In the beginning, 0.050 g of PCBM (Phenyl C61-butyric acid methyl ester) (product name: E100, manufactured by Frontier Carbon Corporation) was weighed and dichlorobenzene was added thereto to be 0.5 g, thereby a 10% by weight solution was prepared. When the solution was heated to 100°C under stirring, PCBM was completely dissolved and, when the solution was returned to room temperature, no precipitate was found. Thereby, it was confirmed that PCBM was dissolved 10% by weight or more (that is, PCBM is 10% by weight or more to a mixed solution of PCBM and dichlorobenzene) in dichlorobenzene.

In the next place, 0.03 g of the polymer A was weighed and dichlorobenzene was added thereto to be 2 g, thereby a 1.5% by weight solution was prepared. When the solution was heated to 100°C under stirring, the polymer A was completely dissolved. When the solution was returned to room temperature and tried to filter with a membrane filter, it was found that a 0.2 µm filter was used to filter, that is, the solubility was excellent. Separately, a 1.5% by weight dichlorobenzene solution of PCBM was prepared, the respective solutions were mixed at a ratio of polymer A: PCBM = 1: 1 (weight base), thereby a coating solution was prepared. A glass substrate that has ITO and was ultrasonic cleansed with acetone was subjected to ozone-UV irradiation treatment to cleanse a surface of the glass substrate. The coating solution was coated by means of a spin coat method to form a mixed film of the polymer A and PCBM at a thickness of 60 nm and thereby a homogeneous and flat organic film was obtained. Thereon, an aluminum electrode was deposited at a thickness of 70 nm by a vacuum deposition method and thereby an organic photoelectric conversion device A having an effective area of 2 × 2 mm² was prepared.

### · Evaluation of Characteristics of Organic Thin Film Solar Battery

Simulated sunlight (an amount of passed air (AM1.5), radiation illuminance (100 mW/cm²)) of a solar simulator was illuminated on an organic photoelectric conversion device A to measure characteristics of a solar battery. As the characteristics thereof, an open voltage of 0.58 V, a short-circuit current of 2.6 mA/cm² and photoelectric conversion efficiency of 0.57% were obtained.

### · Evaluation of Photodetector Characteristics

Dark current-voltage characteristics of an organic photoelectric conversion device A were measured without illuminating light. A dark current of -3.2 × 10⁻⁵ mA/cm² flowed when a voltage of -1 V was applied to ITO. In the next place, the current-voltage characteristics under light illumination were measured by illuminating white light of 4 mW/cm². A photocurrent of -0.36 mA/cm² flowed when a voltage of -1 V was applied to ITO. A ratio of the light current to the dark current was 1.1 × 10⁴.

### <Comparative Example 1>

### · Preparation of Organic Photoelectric Conversion Device

A 1.5% by weight dichlorobenzene solution of the polymer B was prepared in the same manner as in Example 4. When the solution was heated to 100°C under stirring, the polymer B was completely dissolved. When the solution was returned to room temperature and a membrane filter was tried to filter, even a 1 µm filter could not filter, that is, the solubility was inferior. Without filtering, 1.5% by weight dichlorobenzene solutions of the polymer B and PCBM were mixed at 1: 1 (based on weight) to prepare a solution, and the solution was coated by means of a spin coat method to form a mixed film of the polymer B and PCBM at a thickness of substantially 80 nm. However, a homogeneous and flat organic film was not obtained. That is, the film was inhomogeneous. Thereon, an aluminum electrode was deposited at a thickness of 70 nm by a vacuum deposition method and thereby an organic photoelectric conversion device B having an effective area of 2 × 2 mm² was prepared.

### · Evaluation of Characteristics of Organic Thin Film Solar Battery

The solar battery characteristics were measured in the same manner as in Example 3 with an organic photoelectric conversion device B. As the characteristics thereof, an open voltage of 0.58 V, a short-circuit current of 0.87 mA/cm² and photoelectric conversion efficiency of 0.24% were obtained.

### <Example 4>

### · Preparation of Organic Photoelectric Conversion Device

A 1.5% by weight dichlorobenzene solution of the polymer C was prepared in the same manner as in Example 3. When the solution was heated to 100°C under stirring, the polymer C was completely dissolved. When the solution was returned to room temperature and a membrane filter was tried to filter, a 0.2 µm filter was capable of filtering. That is, the solubility was excellent. 1.5% by weight dichlorobenzene solutions of the polymer C and PCBM were mixed at 1: 1 (based on weight) to prepare a coating solution, and the coating solution was coated by means of a spin coat method to form a mixed film of the polymer C and PCBM at a thickness of 85 nm. A homogeneous and flat organic film was obtained. Thereon, an aluminum electrode was deposited at a thickness of 70 nm by a vacuum deposition method and thereby an organic photoelectric conversion device C having an effective area of 2 × 2 mm² was prepared.

### · Evaluation of Characteristics of Organic Thin Film Solar Battery

The solar battery characteristics were measured in the same manner as in Example 3 with an organic photoelectric conversion device C. As the characteristics thereof, an open voltage of 0.61 V, a short-circuit current of 3.04 mA/cm² and photoelectric conversion efficiency of 1.0% were obtained.

### <Example 5>

### · Preparation of Organic Photoelectric Conversion Device

In the same manner as in Example 3, the polymer A and PCBM were mixed at a ratio of 1: 2 (based on weight) to prepare a solution. The solution was coated by use of a spin coat method to form a mixed film of the polymer A and PCBM at a thickness of 140 nm and thereby a homogeneous organic film was obtained. On the organic film, BCP (Bathocuproine: 2,9-Dimethyl-4,7-diphenyl-1,10-phenanthroline, manufactured by Aldrich) was deposited at a film thickness of 50 nm by means of a vacuum deposition method, followed by depositing an aluminum electrode at a thickness of 70 nm, and thereby an organic photoelectric conversion device D having an effective area of 2 × 2 mm² was prepared.

### · Evaluation of Characteristics of Organic Thin Film Solar Battery

The solar battery characteristics were measured in the same manner as in Example 3 with an organic photoelectric conversion device D. As the characteristics thereof, an open voltage of 0.83 V, a short-circuit current of 4.0 mA/cm² and photoelectric conversion efficiency of 2.3% were obtained.

### <Example 6>

### · Preparation of Organic Photoelectric Conversion Device

A 1.5% by weight dichlorobenzene solution of the polymer C was prepared in the same manner as in Example 3. When the solution was heated to 100°C under stirring, the polymer C was completely dissolved. When the solution was returned to room temperature and a membrane filter was tried to filter, a 0.2 µm filter was capable of filtering. That is, the solubility was excellent. 1.5% by weight dichlorobenzene solutions of the polymer C and PCBM were mixed at 1: 2 (based on weight) to prepare a coating solution. The coating solution was coated by means of a spin coat method to form a mixed film of the polymer C and PCBM at a thickness of 85 nm. A homogeneous and flat organic film was obtained. Thereon, BCP was deposited at a film thickness of 50 nm by use a vacuum deposition method and after that an aluminum electrode was deposited at a thickness of 70 nm, and thereby an organic photoelectric conversion device E having an effective area of 2 × 2 mm² was prepared.

### · Evaluation of Characteristics of Organic Thin Film Solar Battery

The solar battery characteristics were measured in the same manner as in Example 3 with an organic photoelectric conversion device E. As the characteristics thereof, an open voltage of 0.78 V, a short-circuit current of 3.47 mA/cm² and photoelectric conversion efficiency of 1.3% were obtained.

### <Example 7>

### · Preparation of Organic Photoelectric Conversion Device

In the beginning, 0.050 g of PCBNB (Phenyl C61-butyric acid n-butyl ester) (product name: E200, manufactured by Frontier Carbon Corporation) was weighed and xylene was added thereto to be 0.5 g, thereby a 10% by weight solution was prepared. When the solution was heated to 100°C under stirring, PCBNB was completely dissolved and, when the solution was returned to room temperature, no precipitate was found. Thereby, it was confirmed that PCBNB was dissolved 10% by weight or more (that is, PCBNB is 10% by weight or more to a mixed solution of PCBNB and xylene) in xylene.

In the same manner as in Example 3, a 1.5% by weight xylene solution of the polymer A was prepared. When the solution was heated to 100°C under stirring, the polymer was completely dissolved. When the solution was returned to room temperature and tried to filter with a membrane filter, it was found that a 0.2 µm filter was used to filter, that is, the solubility was excellent. A coating solution was prepared by mixing 1.5% by weight xylene solutions respectively containing the polymer A and PCBNB at a ratio of polymer A: PCBNB = 1: 1 (weight base). The coating solution was coated by means of a spin coat method to form a mixed film of the polymer A and PCBNB at a thickness of 70 nm and thereby a homogeneous and flat organic film was obtained. Thereon, an aluminum electrode was deposited at a thickness of 70 nm by a vacuum deposition method and thereby an organic photoelectric conversion device G having an effective area of 2 × 2 mm² was prepared.

### · Evaluation of Characteristics of Organic Thin Film Solar Battery

The solar battery characteristics were measured in a manner similar to Example 3 with an organic photoelectric conversion device G. As the characteristics thereof, an open voltage of 0.64 V, a short-circuit current of 2.20 mA/cm² and photoelectric conversion efficiency of 0.56% were obtained.

### <Evaluation>

In Table 1, characteristics of polymers synthesized and organic photoelectric conversion devices prepared in examples and comparative example are summarized. As obvious from examples, polymers of the invention are excellent in the solubility in organic solvents and have high charge transportability. Accordingly, when the polymers of the invention are used to prepare organic photoelectric conversion devices, charges generated by photoelectric conversion may be efficiently transported to electrodes. As the result, resulted organic photoelectric conversion devices exhibited high photoelectric conversion efficiency. Furthermore, when a buffer layer was disposed between an organic layer containing a polymer of the invention and an electrode, the photoelectric conversion efficiency was more improved. Still furthermore, in preferable embodiments, when a fullerene derivative high in the solubility in xylene was combined, the polymers of the invention were dissolved in organic solvents other than halogenated solvents high in the environment burden and photoelectric conversion devices homogeneous in film quality were prepared. Furthermore, it was confirmed that the devices exhibit high photoelectric conversion efficiency.

**Table 1**

| | Electron donor compound | Electron acceptor compound | Ratio (by weight) | Solvent | Solubility | Organic photoelectric conversion device | Buffer layer | Photoelectric conversion efficiency (%) |
|---|---|---|---|---|---|---|---|---|
| Example 3 | Polymer A | PCBM | 1:1 | DCB | ○ | A | No | 0.57 |
| Comparative Example 1 | Polymer B | PCBM | 1:1 | DCB | × | B | No | 0.24 |
| Example 4 | Polymer C | PCBM | 1:1 | DCB | ○ | C | No | 1.0 |
| Example 5 | Polymer A | PCBM | 1:2 | DCB | ○ | D | BCP | 2.3 |
| Example 6 | Polymer C | PCBM | 1:2 | DCB | ○ | E | BCP | 1.3 |
| Example 7 | Polymer A | PCBMB | 1:1 | Xylene | ○ | G | No | 0.56 |

| | | | | | | | | |
|---|---|---|---|---|---|---|---|---|
| * In the table, in a column of solubility, marks ○ and × mean [○]: [filtration with a membrane filter was possible] and [×]: [filtration with a membrane filter was impossible]. Furthermore, [DCB] means dichlorobenzene. | | | | | | | | |

### <Example 7>

With 7,7-dioctylbenzo[3,4]fluorene-5,9-diboric acid dimethyl ester (1.369 g, 1.975 mmol) and 5,5''''-3'',4''-dihexyl-a-pentathiophene (1.461 g, 1.965 mmol), according to a method described in WO2005/092947, 1.88 g of a polymer D represented by a formula shown below was synthesized. The number average molecular weight in terms of polystyrene of the polymer D was 3.6 × 10⁴. 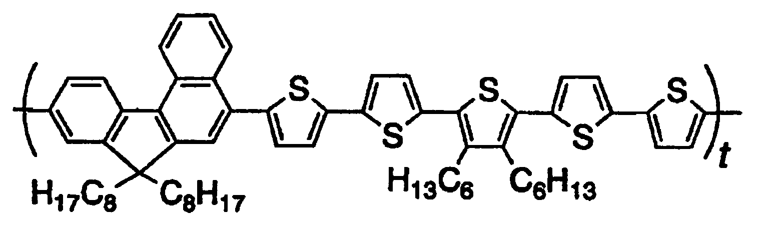 (In the formula, t represents a degree of polymerization.)

### <Example 8>

### · Preparation of Organic Photoelectric Conversion Device

In the beginning, 0.050 g of PCBM (Phenyl C61-butyric acid methyl ester) (product name: E100, manufactured by Frontier Carbon Corporation) was weighed and dichlorobenzene was added thereto to be 0.5 g, thereby a 10% by weight solution was prepared. When the solution was heated to 100°C under stirring, PCBM was completely dissolved and, when the solution was returned to room temperature, no precipitate was found. Thereby, it was confirmed that PCBM was dissolved 10% by weight or more (that is, PCBM is 10% by weight or more to a mixed solution of PCBM and dichlorobenzene) in dichlorobenzene.

In the next place, 0.030 g of the polymer D was weighed and dichlorobenzene was added thereto to be 2 g, thereby a 1.5% by weight solution was prepared. When the solution was heated to 100°C under stirring, the polymer D was completely dissolved. When the solution was returned to room temperature and tried to filter with a membrane filter, it was found that a 0.2 µm filter was used to filter, that is, the solubility was excellent. Separately, a 1.5% by weight dichlorobenzene solution of PCBM was prepared, the respective solutions were mixed at a ratio of polymer A: PCBM = 1: 2 (weight base), thereby a coating solution was prepared. A glass substrate that has ITO and is ultrasonic cleansed with acetone was subjected to an ozone-UV irradiation treatment to cleanse a surface thereof. The coating solution was coated by means of a spin coat method to form a mixed film of the polymer A and PCBM at a thickness of 83 nm and thereby a homogeneous and flat organic film was obtained. Thereon, according to a vacuum deposition method, BCP was deposited at a film thickness of 50 nm and thereafter an aluminum electrode was deposited at a thickness of 70 nm, and thereby an organic photoelectric conversion device H having an effective area of 2 × 2 mm² was prepared.

### · Evaluation of Characteristics of Organic Thin Film Solar Battery

Simulated sunlight (an amount of passed air (AM1.5), radiation illuminance (100 mW/cm²)) of a solar simulator was illuminated on the organic photoelectric conversion device H to measure solar battery characteristics. As the characteristics thereof, an open voltage of 0.75 V, a short-circuit current of 5.71 mA/cm² and photoelectric conversion efficiency of 0.74% were obtained.

### <Example 9>

### · Preparation of Organic Photoelectric Conversion Device

A 1.5% by weight dichlorobenzene solution of the polymer A was prepared in the same manner as in Example 8. Then, 1.5% by weight dichlorobenzene solutions of the polymer A and PCBM were mixed at 1: 1 (based on weight) to prepare a coating solution, and the coating solution was coated by means of a spin coat method to form a mixed film of the polymer A and PCBM at a thickness of 85 nm. A homogeneous and flat organic film was obtained. Thereon, an aluminum electrode was deposited at a thickness of 70 nm by a vacuum deposition method and thereby an organic photoelectric conversion device I having an effective area of 2 × 2 mm² was prepared.

### · Evaluation of Characteristics of Organic Thin Film Solar Battery

The solar battery characteristics were measured in a manner similar to Example 8 with an organic photoelectric conversion device I. As the characteristics thereof, an open voltage of 0.55 V, a short-circuit current of 2.51 mA/cm² and photoelectric conversion efficiency of 0.55% were obtained.

### <Evaluation>

As obvious from examples, polymers of the invention are excellent in the solubility in organic solvents and have high charge transportability. Accordingly, when the polymers of the invention are used to prepare organic photoelectric conversion devices, charges generated by photoelectric conversion may be efficiently transported to electrodes. As the result, resulted organic photoelectric conversion devices exhibited high photoelectric conversion efficiency. Furthermore, it was confirmed that when a buffer layer was disposed between an organic layer containing a polymer of the invention and an electrode, the photoelectric conversion efficiency was more improved.

### INDUSTRIAL APPLICABILITY

Polymers of the invention are excellent in both of the charge transportability and the solubility in organic solvents. Accordingly, the polymers are particularly useful for production of organic semiconductors, organic photoelectric conversion devices, organic thin film solar battery modules, organic image sensors and so on. Organic semiconductors, organic photoelectric conversion devices, organic thin film solar battery modules, organic image sensors and so on, which are produced by use of the polymers of the invention, are excellent in the charge transportability. Furthermore, at the production thereof, the polymers of the invention are high in the solubility in organic solvents (in particular, the solubility in organic solvents at temperatures in the vicinity of room temperature (10 to 50°C) is high). Accordingly, it is advantageous also in that a coating method is applied to prepare an organic layer (or organic thin film) having homogeneous film quality. Furthermore, the polymers of the invention are excellent as well in the photoelectric conversion efficiency when the polymers of the invention are applied to organic photoelectric conversion devices.

## Claims

1. A polymer comprising a repeating unit (repeating unit A) comprising one structural unit represented by a formula (1) shown below, one structural unit represented by a formula (2) shown below and at least one structural unit represented by a formula (3) shown below, wherein a difference between a maximum carbon number of a carbon main chain contained in an alkyl group represented by R¹ or R² and a maximum carbon number of a carbon main chain contained in an alkyl group represented by R³ or R⁴ is 0 or 1: 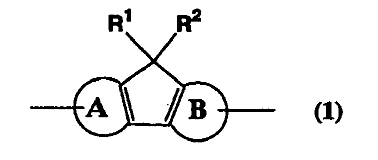 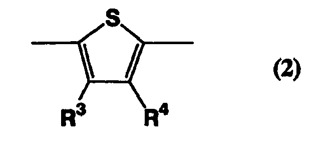 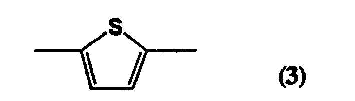 wherein an A ring and a B ring each independently represent an optionally substituted benzene ring and have a bond on the benzene ring; R¹, R², R³ and R⁴ each independently represent a hydrogen atom, a straight or branched alkyl group having 1 to 20 carbon atoms, an alkoxy group having 1 to 20 carbon atoms or an aryl group having 6 to 60 carbon atoms, where some of or all of hydrogen atoms in the groups may be replaced by fluorine atom(s) and the aryl group may be optionally substituted; provided that at least one of R¹ and R² is the alkyl group, and at least one of R³ and R⁴ is the alkyl group.

2. The polymer according to claim 1, wherein the R¹, R², R³ and R⁴ are a straight or branched alkyl group having 5 to 20 carbon atoms.

3. The polymer of claim 1, wherein 2 or 3 contiguous structural units represented by the formula (3) forms a structural unit represented by a formula (7) or (8) shown below.

4. The polymer according to claim 1, comprising a repeating unit having a structure where the structural unit represented by the formula (2) and the structural unit represented by the formula (3) are linked together by at least 4 in total.

5. The polymer according to claim 4, wherein the structural unit represented by the formula (2) and the structural unit represented by the formula (3) together form a structural unit represented by a formula (9) shown below: 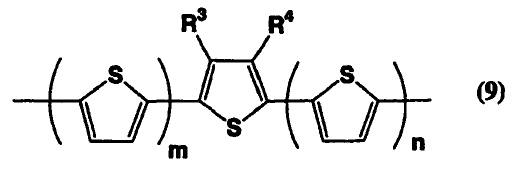 wherein R³ and R⁴ have the same meanings as described above; and m and n each independently represent an integer from 1 to 3; provided that the sum of m and n is an integer from 3 to 6.

6. The polymer according to any one of claims 1 to 5, further comprising a repeating unit (repeating unit B) comprising one structural unit represented by a formula (10) shown below, one structural unit represented by a formula (11) shown below and at least one structural unit represented by the formula (3) wherein a ratio of the repeating unit A to a total of repeating units exceeds 50% by mol: 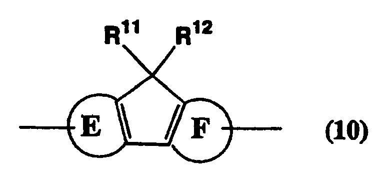 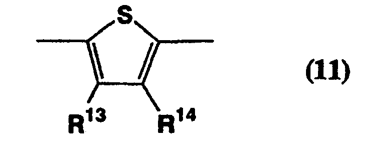 wherein an E ring and an F ring each independently represent an optionally substituted benzene ring or an optionally substituted naphthalene ring and have a bond on the optionally substituted benzene ring or on the optionally substituted naphthalene ring; R¹¹, R¹², R¹³ and R¹⁴ each independently represent a hydrogen atom, an alkyl group having 1 to 20 carbon atoms, an alkoxy group having 1 to 20 carbon atoms or an aryl group having 6 to 60 carbon atoms, some of or all of hydrogen atoms in the groups may be replaced by fluorine atom(s) and the aryl group may be substituted; provided that at least one of R¹³ and R¹⁴ is not a hydrogen atom; provided that when the E ring and F ring are a benzene ring and any one of R¹¹ and R¹² is an alkyl group, a difference between a maximum carbon number of a carbon main chain contained in the alkyl group represented by R¹¹ or R¹² and a maximum carbon number of a carbon main chain contained in the alkyl group represented by R¹³ or R¹⁴ is 2 or more.

7. The polymer according to any one of claims 1 to 6, wherein a number average molecular weight in terms of polystyrene is from 10³ to 10⁸.

8. A composition comprising the polymer according to any one of claims 1 to 7.

9. An organic photoelectric conversion device comprising a pair of electrodes at least one of which is transparent or semitransparent, a first organic layer disposed between the electrodes and containing an electron acceptor compound, and a second organic layer disposed adjacent to the first organic layer and containing an electron donor compound, wherein the electron donor compound is the polymer according to any one of claims 1 to 7.

10. The organic photoelectric conversion device according to claim 9, wherein a buffer layer is disposed between the first organic layer containing an electron acceptor compound and one of the electrodes.

11. An organic photoelectric conversion device comprising a pair of electrodes at least one of which is transparent or semitransparent, and at least one organic layer disposed between the electrodes and containing an electron acceptor compound and an electron donor compound, wherein the electron donor compound is the compound according to any one of claims 1 to 7.

12. The organic photoelectric conversion device according to claim 11, wherein a buffer layer is disposed between the organic layer containing an electron acceptor compound and an electron donor compound and one of the electrodes.

13. The organic photoelectric conversion device according to claim 10 or 12, wherein the buffer layer contains bathocuproine.

14. The organic photoelectric conversion device according to any one of claims 9 to 13, wherein the electron acceptor compound is a compound selected from the group consisting of fullerene and fullerene derivatives.

15. The organic photoelectric conversion device according to claim 14, wherein the fullerene derivative is a fullerene derivative dissolvable by 10 parts by weight or more in 90 parts by weight of dichlorobenzene.

16. The organic photoelectric conversion device according to claim 14, wherein the fullerene derivative is a fullerene derivative dissolvable by 10 parts by weight more in 90 parts by weight of xylene.

17. An organic thin film comprising the polymer according to any one of claims 1 to 7.

18. The organic thin film according to claim 17 further comprising an anti-oxidizing agent and/or a UV absorbent.

19. An organic thin film solar battery module formed by stacking a plurality of the organic photoelectric conversion devices according to any one of claims 9 to 16.

20. An organic image sensor formed by stacking a plurality of the organic photoelectric conversion devices according to any one of claims 9 to 16.

21. A polymer comprising a repeating unit (repeating unit C) comprising one structural unit represented by a formula (19) shown below, one structural unit represented by a formula (20) shown below and at least one structural unit represented by a formula (21) shown below. 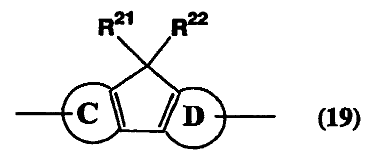 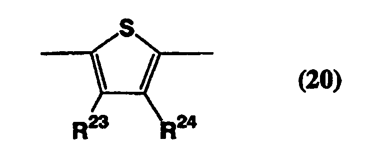 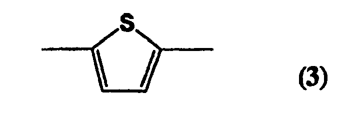 wherein a C ring and a D ring each independently represent an optionally substituted aromatic ring and have a bond on the aromatic ring; R²¹, R²², R²³ and R²⁴ each independently represent a hydrogen atom, an alkyl group having 1 to 20 carbon atoms, an alkoxy group having 1 to 20 carbon atoms or an aryl group having 6 to 60 carbon atoms, where some of or all of hydrogen atoms in the groups may be replaced by fluorine atom(s) and the aryl group may be optionally substituted; provided that at least one of R²³ and R²⁴ is not a hydrogen atom, and at least one of the C ring and the D ring is not a benzene ring.

22. The polymer according to claim 21, wherein R²¹, R²², R²³ and R²⁴ each are a straight or branched alkyl group having 5 to 20 carbon atoms.

23. The polymer according to claim 21, wherein at least one of the C ring and the D ring is an optionally substituted naphthalene ring.

24. The polymer according to claim 21, wherein 2 or 3 structural units represented by the formula (21) are contiguous.

25. The polymer according to claim 21, comprising a repeating unit having a structure where the structural unit represented by the formula (20) and the structural unit represented by the formula (21) are linked together by at least 4.

26. The polymer according to claim 5, wherein the structural unit represented by the formula (20) and the structural unit represented by the formula (21) together form a structural unit represented by a formula (23) shown below. 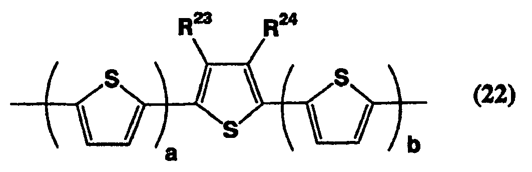 wherein R²³ and R²⁴ have the same meanings as that described above, and m and n each independently represent an integer from 1 to 3; provided that a total of a and b is an integer from 3 to 6.

27. The polymer according to claim 21, further comprising a repeating unit (repeating unit D) comprising one structural unit represented by a formula (23) shown below, one structural unit represented by a formula (24) shown below and at least one structural unit represented by the formula (3), wherein a ratio of the repeating unit C to a total of repeating units exceeds 50% by mol. 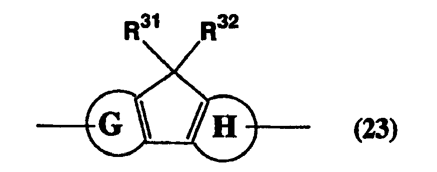 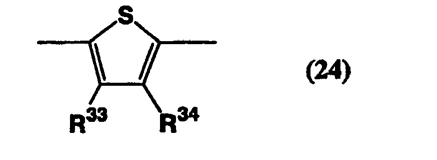 wherein a G ring and an H ring each independently represent an optionally substituted benzene ring and have a bond on the optionally substituted benzene ring; R²¹, R²², R²³ and R²⁴ each independently represent a hydrogen atom, an alkyl group having 1 to 20 carbon atoms, an alkoxy group having 1 to 20 carbon atoms or an aryl group having 6 to 60 carbon atoms, some of or all of hydrogen atoms in the groups may be replaced by fluorine atom(s) and the aryl group may be optionally substituted.

28. The polymer according to claim 21, wherein a number average molecular weight in terms of polystyrene is 10³ to 10⁸.

29. A composition comprising the polymer according to any one of claims 21 to 28.

30. An organic photoelectric conversion device comprising a pair of electrodes at least one of which is transparent or semitransparent, a first organic layer disposed between the electrodes and containing an electron acceptor compound, and a second organic layer disposed adjacent to the first organic layer and containing an electron donor compound, wherein the electron donor compound is the polymer according to any one of claims 21 to 28.

31. The organic photoelectric conversion device according to claim 30, wherein a buffer layer is disposed between the first organic layer containing an electron acceptor compound and one of the electrodes.

32. An organic photoelectric conversion device comprising a pair of electrodes at least one of which is transparent or semitransparent, and at least one organic layer disposed between the electrodes and containing an electron acceptor compound and an electron donor compound, wherein the electron donor compound is the polymer according to any one of claims 21 to 28.

33. The organic photoelectric conversion device according to claim 32, wherein a buffer layer is formed between the organic layer containing an electron acceptor compound and an electron donor compound and one of the electrodes.

34. The organic photoelectric conversion device according to claim 31 or 33, wherein the buffer layer contains bathocuproine.

35. The organic photoelectric conversion device according to claim 30, wherein the electron acceptor compound is a compound selected from the group consisting of fullerene and fullerene derivatives.

36. The organic photoelectric conversion device according to claim 35, wherein the fullerene derivative is a fullerene derivative dissolvable by 10 parts by weight or more in 90 parts by weight of dichlorobenzene.

37. The organic photoelectric conversion device according to claim 35, wherein the fullerene derivative is a fullerene derivative dissolvable by 10 parts by weight or more in 90 parts by weight of xylene.

38. An organic thin film comprising the polymer according to any one of claims 21 to 28.

39. The organic thin film according to claim 38 further comprising an anti-oxidizing agent and/or a UV absorbent.

40. An organic thin film solar battery module formed by stacking a plurality of the organic photoelectric conversion devices according to claim 30.

41. An organic image sensor formed by stacking a plurality of the organic photoelectric conversion devices according to claim 30.
